(19) Europäisches Patentamt
European Patent Office
Office européen des brevets

(11) **EP 4 776 069 A1**

(12) **EUROPEAN PATENT APPLICATION**
published in accordance with Art. 153(4) EPC

(43) Date of publication:
**15.07.2026 Bulletin 2026/29**

(21) Application number: **25815986.2**

(22) Date of filing: **27.05.2025**

(51) International Patent Classification (IPC):
***G03F 7/004*** *(2006.01)* ***G03F 7/075*** *(2006.01)*
***G03F 7/027*** *(2006.01)* ***G03F 7/035*** *(2006.01)*
***G03F 7/031*** *(2006.01)* ***G03F 7/105*** *(2006.01)*

(52) Cooperative Patent Classification (CPC):
**G03F 7/004; G03F 7/027; G03F 7/031; G03F 7/035; G03F 7/075; G03F 7/105**

(86) International application number:
**PCT/KR2025/007183**

(87) International publication number:
**WO 2025/249876 (04.12.2025 Gazette 2025/49)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **28.05.2024 KR 20240069111**
**22.05.2025 KR 20250066800**

(71) Applicant: **Taiyo Ink Mfg Co., (Korea) Ltd.**
**Gyeonggi-do 15407 (KR)**

(72) Inventors:
- **KWON, Jongchul**
  **Ansan-si Gyeonggi-do 15407 (KR)**
- **LIM, Seok Bong**
  **Ansan-si Gyeonggi-do 15407 (KR)**
- **SA, Young Ho**
  **Ansan-si Gyeonggi-do 15407 (KR)**
- **KIM, Kang Soo**
  **Ansan-si Gyeonggi-do 15407 (KR)**
- **JO, Jae Hun**
  **Ansan-si Gyeonggi-do 15407 (KR)**

(74) Representative: **Winter, Brandl - Partnerschaft mbB**
**Alois-Steinecker-Straße 22**
**85354 Freising (DE)**

# (54) PHOTOSENSITIVE RESIN COMPOSITION, DRY FILM, CURED PRODUCT, AND PRINTED CIRCUIT BOARD

(57) An embodiment of the present disclosure relates to a photosensitive resin composition comprising (A) a carboxyl group-containing resin, (B) a photopolymerization initiator, and (C) an inorganic filler, wherein the photopolymerization initiator (B) comprises at least one moiety represented by chemical formula 1. In the photosensitive resin composition, a solder resist layer formed through a combination of four components shows a low moisture absorption rate and moisture permeability and undergoes less ion migration even after HAST evaluation. In addition, the composition has excellent thermal stability and therefore generates less outgas. Due to these characteristics, the photosensitive resin composition of the present disclosure can exhibit an excellent effect as a solder resist.

FIG. 1

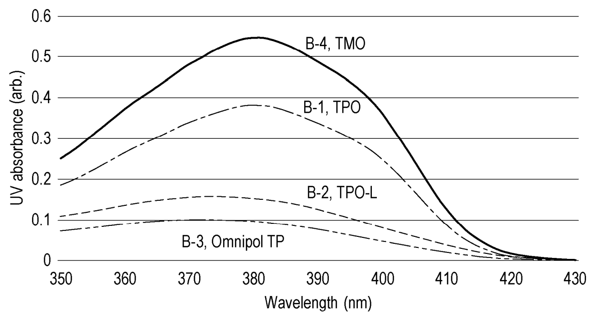


EP 4 776 069 A1

## Description

TECHNICAL FIELD

The present disclosure relates to a photosensitive resin composition, a dry film, a cured product, and a printed wiring board. More specifically, the dry film includes a photosensitive resin layer formed by coating and drying the photosensitive resin composition on a first film, the cured product is obtained by curing the photosensitive resin composition or the photosensitive resin layer of the dry film, and the printed wiring board includes the cured product.

BACKGROUND

In general, electrodes are formed by etching a copper foil laminated on a laminate along circuit wiring, and electronic components are mounted at predetermined positions and soldered. A solder resist coating film is used as a protective layer for circuits when electronic components are soldered onto such printed wiring boards. The solder resist coating film prevents solder from adhering to unnecessary portions during soldering and also prevents circuit conductors from being directly exposed to air and corroded by oxygen or moisture. Since oxidation or corrosion of electrodes caused by oxygen or moisture degrades the reliability of electronic devices, preventing such oxidation or corrosion is important. For this reason, it is important to improve the adhesion of the solder resist coating film and to reduce the moisture absorption and water vapor permeability of the solder resist coating film. When the solder resist coating film has low moisture absorption and low water vapor permeability, excellent HAST resistance and reduced ion migration can be achieved, thereby preventing oxidation and corrosion of electrodes and maintaining high reliability in electronic devices.

Meanwhile, there is a growing trend of mounting light-emitting diodes (LEDs) that emit low-power light-used in computer monitors, laptops, televisions, automotive displays and headlamps, mini-LED displays, and backlights for LED displays, as well as light sources for lighting fixtures and PCBs-directly onto printed wiring boards having a white solder resist coating formed thereon. In addition, colored solder resist coating films of various colors (blue, red, green, yellow, and black) are also used on PCBs or component substrates of electronic devices such as electronic clocks, electronic wristwatches, earphones, smartphones, cameras, and micro-LED displays. For solder resist coating films used in these electronic devices as well, it is necessary to reduce moisture absorption and enhance thermal stability.

From this viewpoint, there is a demand for a dry film and a method for manufacturing a printed wiring board including a solder resist layer of a composition that exhibits low moisture absorption and low water vapor permeability, while also providing excellent HAST resistance and reduced ion migration, solely by changing the composition without adding an additional sheet or film on the solder resist coating film.

[Related Art Document]

[Patent Literature]

(Patent Literature 1) Korean Patent No. 10-2022-0086524 A
(Patent Literature 2) Korean Patent No. 10-2024-0147558 A

DISCLOSURE

TECHNICAL PROBLEM

The present disclosure aims to provide a photosensitive resin composition capable of forming a solder resist having excellent absorbance in a UV region (for example, 350 to 430 nm), thereby achieving superior surface curing, increasing the reaction rate of acrylates, and reducing moisture absorption and water permeability.

Also, the present disclosure is to provide a photosensitive resin composition capable of forming a solder resist that maintains high reflectance and exhibits reduced ion migration even when subjected to long-term reliability evaluation for an extended period of time (for example, 1,000 hours) under severe high-temperature and high-humidity condition.

In addition, the present disclosure is to provide a photosensitive resin composition having excellent thermal stability and capable of reducing the generation of outgas.

Furthermore, the present disclosure is to provide a dry film, a cured product, a printed wiring board, and a laminate using the photosensitive resin composition.

The present disclosure is intended to provide white and/or colored solder resist compositions. More specifically, the present disclosure provides white and/or colored solder resist compositions having low moisture absorption and low

water vapor permeability, excellent pencil hardness, reduced ion migration after HAST evaluation, and a low outgas content, as well as solder resist layers obtained therefrom, dry films and printed wiring boards including the same, and methods for manufacturing same.

TECHNICAL SOLUTION

An embodiment of the present disclosure relates to a photosensitive resin composition.

In an aspect, the photosensitive resin composition includes (A) a carboxyl group-containing resin, (B) a photopolymerization initiator, and (C) an inorganic filler, wherein the (B) photopolymerization initiator includes one or more moieties represented by the following Chemical Formula 1:

<Chemical Formula 1>

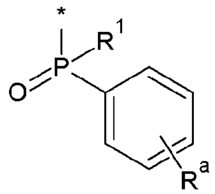

wherein, $R^1$ is a hydrogen atom, a substituted or unsubstituted alkyl group of 1 to 10 carbon atoms, or a substituted or unsubstituted non-aromatic cyclic group or aromatic group of 6 to 20 carbon atoms, $R^a$ is a substituted or unsubstituted alkyl group of 1 to 10 carbon atoms, substituents of the substituted alkyl group of 1 to 10 carbon atoms and the substituted non-aromatic cyclic group or aromatic group are alkyl groups of 1 to 10 carbon atoms, and * denotes a bonding site to an adjacent atom.

In an aspect, the (B) photopolymerization initiator may include one or more moieties represented by the following Chemical Formula 1A.

<Chemical Formula 1A>

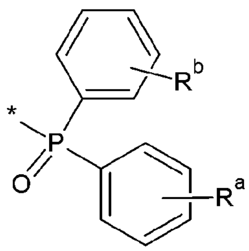

$R^a$ and $R^b$ are each a substituted or unsubstituted alkyl group of 1 to 10 carbon atoms, wherein substituents of the substituted alkyl group of 1 to 10 carbon atoms are alkyl group of 1 to 10 carbon atoms, and * denotes a bonding site to an adjacent atom.

In an aspect, the (B) photopolymerization initiator may include one or more moieties represented by the following Chemical Formula 1-1:

<Chemical Formula 1-1>

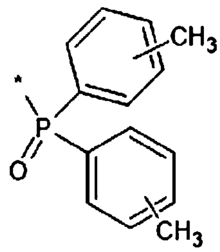

* denotes a bonding site to an adjacent atom.

In an aspect, the (B) photopolymerization initiator is in a solid state at room temperature (25°C) and may have a weight-average molecular weight (Mw) in a range of 350 to 900 g/mol.

In an aspect, the (B) photopolymerization initiator may have a thermal decomposition temperature of 240°C or higher.

In an aspect, the (B) photopolymerization initiator may be represented by the following Chemical Formula 2:

<Chemical Formula 2>

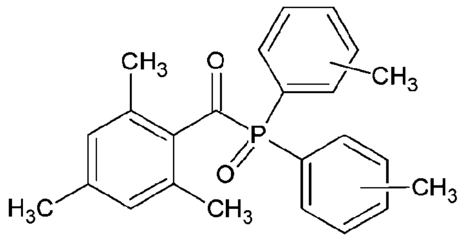

In an aspect, the (B) photopolymerization initiator may be represented by any one of the following Chemical Formulas 3 to 5.

<Chemical Formula 3>

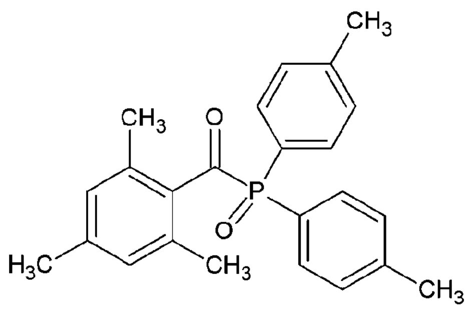

<Chemical Formula 4>

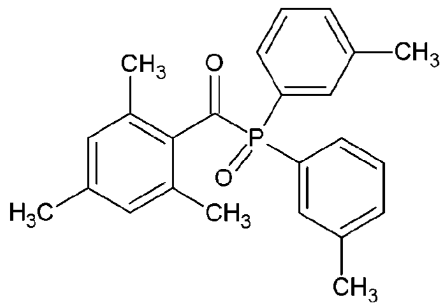

<Chemical Formula 5>

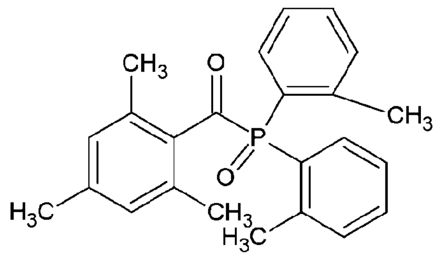

In an aspect, the photosensitive resin composition may further include one or more selected from the group consisting of an oxime-based photopolymerization initiator, an epoxy resin, an acrylic resin, a thermosetting catalyst, a dispersant, and a colorant.

In an aspect, the thermosetting catalyst may be one or more selected from the group consisting of imidazole, melamine, and dicyandiamide, or derivatives thereof.

In an aspect, the colorant may be one or more selected from the group consisting of a white pigment, a black pigment, a blue pigment, and a green pigment.

In an aspect, the content of the (B) photopolymerization initiator may be 0.06 to 20 wt% based on the total weight of the composition.

In an aspect, when the photosensitive resin composition is cured to a thickness of 60 μm and the reflectance of the cured product is measured using a spectrophotometer, the reflectance at 450 nm may be 90% or higher.

In an aspect, the cured product obtained by curing the photosensitive resin composition may have a moisture absorption rate of 5% or less, as measured according to ASTM D570.

In an aspect, the cured product obtained by curing the photosensitive resin composition may have a water vapor transmission rate (WVTR) of 33 $g/m^2 \cdot day$ or less, as measured according to ASTM F1249.

Another embodiment of the present disclosure relates to a dry film having a photosensitive resin layer formed by coating and drying the above-described photosensitive resin composition on a first film.

Another embodiment of the present disclosure relates to a cured product obtained by curing the above-described photosensitive resin composition or the photosensitive resin layer of the dry film obtained therefrom.

Another embodiment of the present disclosure relates to a printed wiring board including the above-described cured product as a solder resist.

ADVANTAGEOUS EFFECTS

The photosensitive resin composition according to an embodiment of the present disclosure has excellent absorbance in a UV region (for example, 350 to 430 nm), thereby providing superior surface curing, increasing the reaction rate of acrylates, and enabling formation of a solder resist having low moisture absorption and low water permeability.

In addition, the photosensitive resin composition according to an embodiment of the present disclosure may form

a solder resist that maintains high reflectance and exhibits reduced ion migration even after long-term reliability evaluation for an extended period of time (for example, 1,000 hours) under severe high-temperature and high-humidity conditions.

In addition, the photosensitive resin composition according to an embodiment of the present disclosure has excellent thermal stability and can reduce the generation of outgas.

Furthermore, the present disclosure may provide a dry film, a cured product, and a printed wiring board using the photosensitive resin composition.

DESCRIPTION OF DRAWINGS

FIG. 1 is a graph showing absorbance in a wavelength range of 350 to 430 nm of a TMO initiator used in the Examples and TPO, TPO-L, and Omnipol TP initiators used in the Comparative Examples.

FIGS. 2A and 2B are graphs showing water vapor transmission rates of dry films prepared using the photosensitive resin compositions of Example 3 and Comparative Example 1.

FIG. 3 provides images showing ion migration occurring after HAST evaluation of dry films prepared using the photosensitive resin compositions of Example 3 and Comparative Example 1.

MODE FOR INVENTION

Hereinafter, a description will be given of various embodiments of the present disclosure.

[Photosensitive Resin Composition]

An embodiment of the present disclosure relates to a photosensitive resin composition comprising (A) a carboxyl group-containing resin, (B) a photopolymerization initiator, and (C) an inorganic filler, wherein the photopolymerization initiator (B) includes one or more moieties represented by the following Chemical Formula 1:

<Chemical Formula 1>

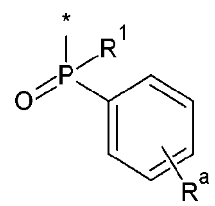

wherein, $R^1$ is a hydrogen atom, a substituted or unsubstituted alkyl group of 1 to 10 carbon atoms, or a substituted or unsubstituted non-aromatic cyclic group or aromatic group of 6 to 20 carbon atoms, $R^a$ is a substituted or unsubstituted alkyl group of 1 to 10 carbon atoms, substituents of the substituted alkyl group of 1 to 10 carbon atoms and the substituted non-aromatic cyclic group or aromatic group are alkyl groups of 1 to 10 carbon atoms, and * denotes a bonding site to an adjacent atom.

The photosensitive resin composition exhibits excellent absorbance in a UV region (for example, 350 to 430 nm), thereby providing superior surface curing. As a result, the reaction rate of acrylates is increased, and a solder resist having a low moisture absorption rate and low water permeability can be formed. In addition, even after long-term reliability evaluation under high-temperature and high-humidity harsh environments (for example, 1,000 hours), a solder resist maintaining high reflectance and exhibiting reduced ion migration can be formed.

Further, the photosensitive resin composition exhibits excellent thermal stability, thereby reducing the generation of outgas.

For example, the photosensitive resin composition may be a composition for forming a white or colored solder resist by curing.

Hereinafter, each component of the photosensitive resin composition will be described in detail.

[(A) Carboxyl Group-Containing Resin]

In the photosensitive resin composition according to an embodiment of the present disclosure, the carboxyl group-containing resin (hereinafter referred to as "resin (A)") may be a resin that is cured by irradiation with an active energy ray and exhibits electrical insulating properties.

Since resin (A) contains carboxyl groups, alkaline development is possible. In addition, in combination with the inorganic filler (B) described below, high reflectance can be achieved, reflectance reduction after a reflow process is minimized, and reflectance reduction after a 3,000-hour blue-light test is suppressed. Accordingly, a composition containing resin (A) exhibits reduced reflectance degradation.

For example, resin (A) may include unsaturated double bonds. By including unsaturated double bonds, resin (A) can undergo radical curing by ultraviolet rays, electron beams, or heat.

Resin (A) is not particularly limited as long as it contains carboxyl groups, and may be, for example, a photosensitive carboxyl group-containing resin having one or more photosensitive unsaturated double bonds per molecule, or a carboxyl group-containing resin not having photosensitive unsaturated double bonds.

For example, resin (A) may suitably be selected from the following resins:

(1) a carboxyl group-containing resin obtained by copolymerization of an unsaturated carboxylic acid and a compound having an unsaturated double bond;
(2) a photosensitive carboxyl group-containing resin obtained by reacting a carboxyl group-containing (meth)acrylic copolymer resin with a compound having an oxirane ring and an ethylenically unsaturated group in one molecule;
(3) a photosensitive carboxyl group-containing resin obtained by reacting a copolymer of a compound having one epoxy group and one unsaturated double bond per molecule and a compound having an unsaturated double bond with an unsaturated monocarboxylic acid, and then reacting a saturated or unsaturated polybasic acid anhydride with a secondary hydroxyl group generated by the reaction; and
(4) a resin containing photosensitive hydroxyl groups and carboxyl groups, obtained by reacting a hydroxyl group-containing polymer with a saturated or unsaturated polybasic acid anhydride, and then reacting a compound having one epoxy group and one unsaturated double bond per molecule with the carboxylic acid generated by the reaction.

For example, resin (A) may be a photosensitive carboxyl group-containing resin of item (2), which is a copolymer resin having carboxyl groups obtained by reacting (a) a carboxyl group-containing (meth)acrylic copolymer resin and (b) a compound having an oxirane ring and an ethylenically unsaturated group in one molecule.

For example, the carboxyl group-containing (meth)acrylic copolymer resin (a) may be obtained by copolymerizing a (meth)acrylic acid ester and a compound having one unsaturated group and at least one carboxyl group per molecule, without limitation. Examples of the (meth)acrylic acid ester constituting the copolymer resin (a) include alkyl (meth)acrylates such as methyl (meth)acrylate, ethyl (meth)acrylate, propyl (meth)acrylate, butyl (meth)acrylate, pentyl (meth)acrylate, and hexyl (meth)acrylate; hydroxyl-containing (meth)acrylic acid esters such as 2-hydroxyethyl (meth) acrylate, hydroxypropyl (meth)acrylate, hydroxybutyl (meth)acrylate, and caprolactone-modified 2-hydroxyethyl (meth) acrylate; and glycol-modified (meth)acrylates such as methoxydiethylene glycol (meth)acrylate, ethoxydiethylene glycol (meth)acrylate, isooctyloxyethylene glycol (meth)acrylate, phenoxytriethylene glycol (meth)acrylate, methoxytriethylene glycol (meth)acrylate, and methoxypolyethylene glycol (meth)acrylate. These may be used alone or in combination of two or more. In the present specification, the term "(meth)acrylate" collectively refers to acrylates and methacrylates, and the same applies to similar expressions.

Examples of the compound having one unsaturated group and at least one carboxyl group per molecule include acrylic acid, methacrylic acid, modified unsaturated monocarboxylic acids in which a chain is extended between the unsaturated group and the carboxylic acid, such as β-carboxyethyl (meth)acrylate, 2-acryloyloxyethyl succinic acid, 2-acryloyloxyethyl hexahydrophthalic acid; unsaturated monocarboxylic acids having ester bonds formed by lactone modification; modified unsaturated monocarboxylic acids having ether bonds; and compounds containing two or more carboxyl groups per molecule such as maleic acid. These may be used alone or in combination of two or more.

Examples of the compound (b) having an oxirane ring and an ethylenically unsaturated group in one molecule include glycidyl (meth)acrylate, α-methyl glycidyl (meth)acrylate, 3,4-epoxycyclohexylmethyl (meth)acrylate, 3,4-epoxycyclohexylethyl (meth)acrylate, 3,4-epoxycyclohexylbutyl (meth)acrylate, and 3,4-epoxycyclohexylmethylamino acrylate. These may be used alone or in combination of two or more. For example, the compound (b) having an oxirane ring and an ethylenically unsaturated group in one molecule may be 3,4-epoxycyclohexylmethyl (meth)acrylate.

For example, resin (A) may have an acid value of 30 to 200 mgKOH/g. When the acid value of resin (A) is 30 mgKOH/g or more, unexposed portions of the solder resist composition film can be easily removed with a weakly alkaline aqueous solution. When the acid value is 200 mgKOH/g or less, water resistance and electrical properties of the cured film can be improved.

For example, resin (A) may have a weight-average molecular weight of 5,000 to 100,000 g/mol. When the weight-average molecular weight is 5,000 g/mol or more, deterioration in tack-free drying properties of the solder resist composition film can be suppressed. When the weight-average molecular weight is 100,000 g/mol or less, deterioration in developability and storage stability of the solder resist composition can be suppressed.

In the photosensitive resin composition of the present disclosure, the content of resin (A) may be 5 to 50 wt%, 10 to 45 wt%, or 12 to 43 wt%, based on the total composition. The composition includes a solid content and a solvent, and the content of resin (A) may be calculated on a solid-content basis.

When the content of resin (A) falls within the above range, excellent yellowing resistance can be achieved, high reflectance can be realized, a solder resist film can be satisfactorily formed, excellent pencil hardness and adhesion can be exhibited, and deterioration in tack-free drying properties and undercut formation of the film can be suppressed.

[(B) Photopolymerization Initiator]

The photosensitive resin composition according to an embodiment of the present disclosure may include, as the photopolymerization initiator (B), a photopolymerization initiator containing one or more moieties represented by the following Chemical Formula 1:

<Chemical Formula 1>

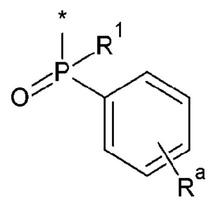

wherein, $R^1$ is a hydrogen atom, a substituted or unsubstituted alkyl group of 1 to 10 carbon atoms, or a substituted or unsubstituted non-aromatic cyclic group or aromatic group of 6 to 20 carbon atoms, $R^a$ is a substituted or unsubstituted alkyl group of 1 to 10 carbon atoms, substituents of the substituted alkyl group of 1 to 10 carbon atoms and the substituted non-aromatic cyclic group or aromatic group are alkyl groups of 1 to 10 carbon atoms, and * denotes a bonding site to an adjacent atom.

The alkyl group of 1 to 10 carbon atoms may be, for example, methyl, ethyl, propyl, butyl, pentyl, hexyl, heptyl, octyl, nonyl, or decyl. The aliphatic cyclic group or aromatic group of 6 to 20 carbon atoms may be, for example, a benzene, toluene, ethylbenzene, propylbenzene, butylbenzene, pentylbenzene, hexylbenzene, heptylbenzene, octylbenzene, nonylbenzene, decylbenzene, naphthalene, or anthracene group. $R^a$ may be substituted at any one of the ortho, meta, or para positions.

In the case of 2,4,6-trimethylbenzoyldiphenyl phosphine oxide (TPO), which is widely used as a conventional photopolymerization initiator, a large amount of outgas is generated during the curing process. Such outgas diffuses into a silicone encapsulant layer, a protective film, or the like, causing yellowing of the silicone encapsulant, thereby reducing reflectance and making it difficult to cure the silicone encapsulant. Thus, there is a problem in long-term reliability of products.

In addition, in the case of TPO, TPO-L, and the like, since UV absorbance is low, a high exposure dose is required, resulting in a long processing time. Further, due to the low absorbance, the reaction rate of acrylates is low, resulting in poor surface curability, high moisture absorption, and high susceptibility to moisture penetration.

Further, since TPO, TPO-L, and the like have low thermal stability, they are easily decomposed by heat to generate a large amount of outgas, thereby causing yellowing of the encapsulant layer and the like.

In contrast, the photosensitive resin composition according to an embodiment of the present disclosure has, as a photopolymerization initiator, a structure in which methyl groups are substituted on phenyl groups bonded to phosphorus (P), thereby exhibiting higher hydrophobicity and having higher thermal stability and UV absorbance. Accordingly, excellent surface curing and a low outgas amount can be achieved.

Further, by using the photopolymerization initiator (B) of the present disclosure described above, due to high absorbance, processing can be performed even with a low exposure dose. Thus, yield is increased by reducing processing time, cost is reduced, and reflectance can be increased. Further, power consumption due to reflectance reduction can be prevented. In addition, even without using a protective film for removing the photopolymerization initiator, the outgas content of the photopolymerization initiator is very low, the curing degree of silicone is greatly increased, long-term

reliability is improved, moisture absorption is low, and water vapor transmission is low, thereby exhibiting excellent HAST resistance and reflectance after the HAST test. Moreover, a decrease in reflectance under high-temperature/high-humidity conditions can be suppressed.

For example, the photopolymerization initiator (B) may include one or more moieties represented by the following Chemical Formula 1A:

<Chemical Formula 1A>

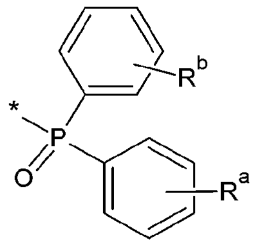

$R^a$ and $R^b$ are each a substituted or unsubstituted alkyl group of 1 to 10 carbon atoms; substituents of the substituted alkyl group of 1 to 10 carbon atoms are alkyl group of 1 to 10 carbon atoms; and * denotes a bonding site to a neighboring atom.

$R^a$ and $R^b$ may be same as or different from each other. $R^a$ and $R^b$ may each be independently substituted at any one of the ortho, meta, or para positions.

For example, the photopolymerization initiator (B) may include one or more moieties represented by the following Chemical Formula 1-1.

<Chemical Formula 1-1>

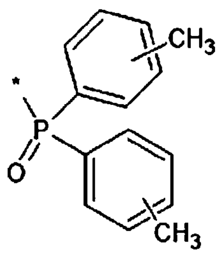

wherein * denotes a bonding site to a neighboring atom.

In Chemical Formula 1-1, the two methyl groups (-CH3) may be independently substituted at any one of the ortho, meta, or para positions.

For example, the photopolymerization initiator (B) may be in a solid state at room temperature (25°C), and may have a weight-average molecular weight (Mw) in a range of 350 to 900 g/mol.

For example, the photopolymerization initiator (B) may have a thermal decomposition temperature of 240°C or higher. When the thermal decomposition temperature of the photopolymerization initiator (B) satisfies the above range, thermal stability is excellent and the initiator is less likely to be decomposed even at high temperatures, and thus the outgas content is low compared to conventional photopolymerization initiators.

For example, the photopolymerization initiator (B) may be represented by the following Chemical Formula 2:

<Chemical Formula 2>

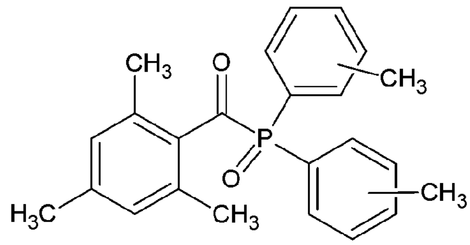

For example, the photopolymerization initiator (B) may be represented by any one of the following Chemical Formulas 3 to 5.

<Chemical Formula 3>

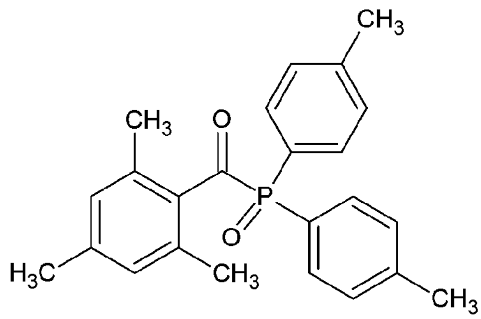

<Chemical Formula 4>

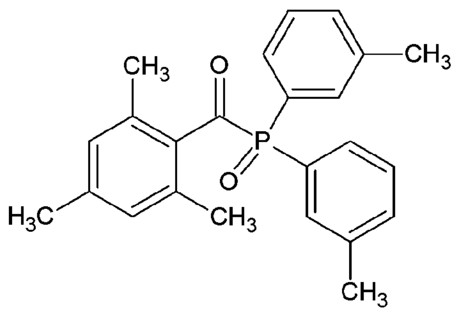

<Chemical Formula 5>

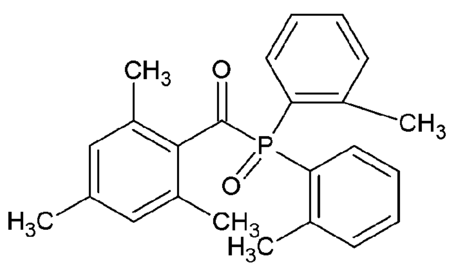

For example, in addition to the photopolymerization initiator (B), one or more photopolymerization initiators

selected from the group consisting of benzoin and alkyl ethers thereof, acetophenones, anthraquinones, thioxanthones, ketals, benzophenones, α-aminoacetophenones, acylphosphine oxides, acylphosphinates, and oxime esters may be further included. Examples of commercially available oxime ester-based photopolymerization initiators include CGI-325, IRGACURE® OXE01, and IRGACURE OXE02 manufactured by BASF Japan, and N-1919 and ADEKA ARKLS® NCI-831 manufactured by ADEKA.

In the photosensitive resin composition of the present disclosure, the content of the photopolymerization initiator (B) may be 0.01 to 25 wt%, 0.01 to 20 wt%, or 0.01 to 18 wt%, based on the total composition. By including the photopolymerization initiator (B) within the above range, the photoreaction rate on copper is excellent and photocurability is sufficient, so that film curability is improved, and film properties such as chemical resistance, solvent resistance, adhesion, and pencil hardness are enhanced, and moisture absorption and water vapor transmission are reduced, and deep curability may also be improved.

In addition, when the content of the photopolymerization initiator (B) falls within the above range, undercut is not severe and halation (top widening phenomenon) is not large, thereby providing excellent resolution and enabling formation of a large number of solder resist openings. Further, high reflectance can be maintained.

[(C) Inorganic Filler]

The photosensitive resin composition according to an embodiment of the present disclosure may achieve high reflectance by including an inorganic filler.

Examples of the inorganic filler include titanium oxide, zinc oxide, basic carbonates, basic sulfates, sulfates, zinc sulfide, antimony oxide, aluminum hydroxide, silica, barium sulfate, and the like. For example, when a composition is prepared using a mixture of barium sulfate and silica as the inorganic filler, the L value may be 80 or more, the a value may be -5 or more, and the b value may be -5 or more. The L value may be measured according to Hunter 1948. For example, when a composition is prepared using a high content of titanium oxide and silica as the inorganic filler, the cured product of the composition may have an L value of 90 or more, an a value of -3 or more, and a b value of -3 or more, indicating high whiteness and high reflectance. For example, when at least one of titanium oxide or silica is used as the inorganic filler, the L value may be 95 or more, the a value may be -2 or more, and the b value may be -1 or more, thereby achieving the highest whiteness and reflectance.

For example, titanium oxide may be produced by either a sulfate process or a chloride process, and may be produced, for example, by a chloride process. For example, sulfuric acid may not be used in the production process. In addition, surface treatment of titanium oxide is not particularly limited, but titanium oxide treated with an acid other than sulfuric acid, such as hydrochloric acid, nitric acid, phosphoric acid, or acetic acid, during neutralization may be used.

Titanium oxide may have a rutile-type, anatase-type, or ramsdellite-type crystal structure, and any one type may be used alone or two or more types may be used in combination. Among these, ramsdellite-type titanium oxide may be obtained by subjecting ramsdellite-type Li0.5TiO2 to a chemical lithium removal treatment.

Among the above, when rutile-type titanium oxide is used, heat resistance may be further improved, discoloration due to light irradiation is less likely to occur, and quality deterioration may be suppressed even under severe use environments. In particular, by using rutile-type titanium oxide surface-treated with an aluminum oxide such as alumina, heat resistance may be improved. The content of rutile-type titanium oxide surface-treated with aluminum oxide, based on the total titanium oxide, may be, for example, 20 wt% or more, for example 55 wt% or more, with an upper limit of 100 wt%, meaning that the entirety of the titanium oxide may be rutile-type titanium oxide surface-treated with aluminum oxide. In addition, since anatase-type titanium oxide has lower hardness than rutile-type titanium oxide, use of anatase-type titanium oxide may improve moldability of the composition. Rutile-type, anatase-type, and ramsdellite-type titanium oxides as inorganic fillers may also be used as white pigments.

In the photosensitive resin composition of the present disclosure, the content of the inorganic filler (C) may be in a range of 20 to 70 wt%, for example 25 to 70 wt%, based on the total resin composition. The content of the inorganic filler (C) may be calculated on a solid-content basis. When the content of the inorganic filler (C) falls within the above range, high reflectance is advantageous; when the content is less than the above range, reflectance decreases; and when the content exceeds the above range, cracks may occur.

Examples of rutile-type titanium oxide produced by the chloride process include T-550, T-580, R-630, R-820, CR-50, CR-60, R-90, and CR-97 manufactured by Ishihara Sangyo Kaisha, Ltd.; Ti-PURE R-706, R-902+, and R931 manufactured by DuPont; TR-600, TR-700, and TR-840 manufactured by Fuji Titanium Industry Co., Ltd.; KR-270, KR-310, and KR-380 manufactured by Titan Kogyo, Ltd.; CR-58, CR-90, and R-630 manufactured by Ishihara Sangyo Kaisha, Ltd.; and R-21 manufactured by Sakai Chemical Industry Co., Ltd.

If the particle size of titanium oxide is too small, flowability may be deteriorated; conversely, if the particle size is too large, insertability into small-diameter portions of a substrate may be deteriorated. In consideration of these factors, the median particle size of titanium oxide may be in a range of 0.1 to 5 μm, for example 0.1 to 1 μm, for example 0.1 to 0.5 μm, and may be 0.36 μm. When the particle size of titanium oxide falls within the above range, high reflectance may be

exhibited. The particle size described above may be measured using a laser diffraction method.

In addition to titanium oxide, inorganic fillers such as barium sulfate, barium titanate, amorphous silica, crystalline silica, fused silica, spherical silica, talc, clay, Neuburg silica earth particles, boehmite, magnesium carbonate, calcium carbonate, aluminum oxide, aluminum hydroxide, silicon nitride, aluminum nitride, calcium zirconate, or metal powders such as copper, tin, zinc, nickel, silver, palladium, aluminum, iron, cobalt, gold, and platinum may be used. The inorganic filler is preferably in the form of spherical particles.

Among the inorganic fillers (C), examples of barium sulfate include precipitated barium sulfate #100, precipitated barium sulfate #300, precipitated barium sulfate SS-50, BARIACE B-30, BARIACE B-31, BARIACE B-32, BARIACE B-33, BARIACE B-34, BARIFINE BF-1, BARIFINE BF-10, BARIFINE BF-20, and BARIFINE BF-40 (manufactured by Sakai Chemical Industry Co., Ltd.), and W-1, W-6, W-10, and C300 (manufactured by Takehara Kagaku Kogyo Co., Ltd.).

Among the inorganic fillers (C), silica particles are not particularly limited and may be obtained by methods known to those skilled in the art. For example, silica particles may be produced by a VMC (Vaporized Metal Combustion) method in which silicon powder is combusted. The VMC method refers to a method in which a chemical flame is formed by a burner in an oxygen-containing atmosphere, and a metal powder constituting part of an oxide particle to be produced is supplied in an amount sufficient to form a dust cloud into the chemical flame to cause knocking, thereby obtaining oxide particles. Examples of commercially available silica include the SO series manufactured by Admatechs Co., Ltd., and the HPS series (HPS-0500, HPS-1000, HPS-3500, etc.) manufactured by Dowa Gosei Co., Ltd.

[Mercapto-Modified (Meth)Acrylate]

In an embodiment of the present disclosure, the photosensitive resin composition may employ a mercapto-modified (meth)acrylate, whereby surface curing is enhanced, gloss is improved, and high reflectance may be achieved.

In addition, when the mercapto-modified (meth)acrylate of the present disclosure is used in the photosensitive resin composition together with the above-described inorganic filler (C), surface curing of the photosensitive resin layer is further improved, and as a result of the enhanced surface curing, even higher reflectance and higher gloss may be realized.

The mercapto-modified (meth)acrylate of the present disclosure is a compound obtained by introducing mercapto groups into an acrylate compound. The acrylate compound may be a mono-functional or multi-functional acrylate compound, and may be an aliphatic compound having 1 to 15 carbon atoms, in which one or more functional groups selected from the group consisting of an acryloyl group, an acryloyloxy group, and an acryloyloxyalkyl group are substituted. Examples thereof include pentane triacrylate.

The mercapto-modified (meth)acrylate of the present disclosure may be curable or actinic-radiation curable. The mercapto-modified (meth)acrylate may be obtained by subjecting a polyfunctional thiol compound and a stoichiometrically excessive amount of a bifunctional or higher polyfunctional (meth)acrylate compound to a Michael addition reaction. Examples of the polyfunctional thiol compound include: pentaerythritol tetrakis(3-mercaptopropionate) (molecular weight 489 g/mol); trimethylolpropane tris(3-mercaptopropionate) (molecular weight 399 g/mol); polyfunctional thiol compounds obtained as reaction products of polyisocyanates such as 1,3-bis(2-isocyanato-2-propyl)benzene with polyfunctional thiol compounds such as trimethylolpropane tris(3-mercaptopropionate); polyfunctional thiol compounds obtained as reaction products of polyisocyanates such as isophorone diisocyanate with polyfunctional thiol compounds such as trimethylolpropane tris(3-mercaptopropionate); polyfunctional thiol compounds obtained as reaction products of polyisocyanates such as hexamethylene diisocyanate with polyfunctional thiol compounds such as trimethylolpropane tris(3-mercaptopropionate); 1,6-hexanedithiol (molecular weight 150 g/mol); ethylene glycol di-2-mercaptoacetate (molecular weight 210 g/mol); pentaerythritol tetrakis(2-mercaptoacetate) (molecular weight 433 g/mol); trimethylolpropane tris(2-mercaptoacetate); and ethylene glycol bis(3-mercaptopropionate) (molecular weight 238 g/mol). For example, the mercapto-modified (meth)acrylate may include two or more mercapto groups, or may include three or more mercapto groups.

The mercapto-modified (meth)acrylate may have a weight-average molecular weight of 5,000 g/mol or less, 3,000 g/mol or less, or 2,000 g/mol or less. When the weight-average molecular weight is 5,000 g/mol or less, the mobility of the mercapto-modified (meth)acrylate molecules is reduced, thereby suppressing a decrease in reactivity during formation of the actinic-radiation-curable coating film of the present disclosure. For example, if such reactivity is reduced, tackiness of the cured coating film surface may increase when the coating film is cured using a UV-LED, and there is a higher possibility that printed matter may adhere to the coating film.

In the photosensitive resin composition of the present disclosure, the content of the mercapto-modified (meth) acrylate may be 1 to 20 parts by weight, 1 to 10 parts by weight, or 1 to 7 parts by weight, based on 100 parts by weight of the total composition.

When the content of the mercapto-modified (meth)acrylate falls within the above range, surface curing is enhanced, gloss is improved, and high reflectance may be achieved; reflectance reduction after the manufacturing process is minimized; and crack resistance may be improved. In addition, deterioration of gloss due to insufficient surface curing may be suppressed, high reflectance may be achieved, the surface may be appropriately cured to reduce

brittleness of the coating film, and resolution may be improved.

[Thermally Curable Acid-Value Resin]

The photosensitive resin composition of the present disclosure includes the carboxyl group-containing resin (A); however, in addition to the resin (A), a thermally curable acid-value resin may be further included.

The thermally curable acid-value resin may exhibit an excellent effect of improving resistance to yellowing through combination with the resin (A). The photosensitive resin composition according to an embodiment of the present disclosure may exhibit excellent yellowing resistance by including the thermally curable acid-value resin in a smaller amount than that of the resin (A).

The thermally curable acid-value resin of the present disclosure may be, for example, a resin that is cured by heating to exhibit electrical insulating properties.

The thermally curable acid-value resin may include one or more selected from the group consisting of a benzene ring, a pyridine ring, a pyrimidine ring, and a triazine ring. Examples of the thermally curable acid-value resin of the present disclosure include melamine resins, silicone resins, and resins having a styrene backbone, and may be, for example, a resin having a styrene backbone.

In addition, the thermally curable acid-value resin may include a carboxyl group, and may be, for example, a carboxyl group-containing resin having a styrene backbone. For example, the thermally curable acid-value resin may be a mixture of a carboxyl group-containing resin having a styrene backbone and a carboxyl group-containing resin other than the carboxyl group-containing resin having a styrene backbone.

For example, when the thermally curable acid-value resin is a carboxyl group-containing resin having a styrene backbone, it may not include a photosensitive group such as an ethylenically unsaturated bond having a carboxyl group in the molecule, may include a styrene backbone in the molecule, may have a weight-average molecular weight of 10,000 to 50,000 g/mol, and may have an acid value of 80 to 200 mgKOH/g. Such a carboxyl group-containing resin having a styrene backbone may be synthesized by copolymerizing styrene as an essential monomer. By using the carboxyl group-containing resin having properties within the above ranges, excellent tack-free dryness of the cured film and an anti-flowing effect may be achieved.

The carboxyl group-containing resin having a styrene backbone may be, for example, a carboxyl group-containing resin (either an oligomer or a polymer) obtained by copolymerization of an unsaturated carboxylic acid such as (meth)acrylic acid with styrene, $\alpha$-methylstyrene, a lower alkyl (meth)acrylate, isobutylene, or an unsaturated compound selected therefrom. Herein, the lower alkyl may refer to an alkyl group having 1 to 5 carbon atoms.

In the photosensitive resin composition of the present disclosure, the weight-average molecular weight of the carboxyl group-containing resin having a styrene backbone may vary depending on the resin backbone, but may be 10,000 g/mol to 50,000 g/mol, 10,000 g/mol to 25,000 g/mol, 10,000 g/mol to 20,000 g/mol, or 10,000 g/mol to 17,000 g/mol. When the weight-average molecular weight is 10,000 g/mol or more, not only is the anti-flowing effect improved, but tack-free dryness is further improved, moisture resistance of the exposed coating film is enhanced, reduction of the film during development is suppressed, and deterioration in resolution may be suppressed. In addition, when the weight-average molecular weight is 50,000 g/mol or less, not only is the anti-flowing effect maintained, but developability and storage stability may also be improved.

In the photosensitive resin composition of the present disclosure, the acid value of the carboxyl group-containing resin having a styrene backbone may be 80 to 200 mgKOH/g, or 100 to 180 mgKOH/g. When the acid value of the carboxyl group-containing resin having a styrene backbone is 80 mgKOH/g or more, the softening point increases, thereby improving tack-free dryness and developability. On the other hand, when the acid value is 200 mgKOH/g or less, appropriate crosslinking density is achieved, so that stress does not occur during curing and a satisfactory coating film may be obtained.

In the photosensitive resin composition of the present disclosure, the carboxyl group-containing resin having a styrene backbone may suppress reduction in reflectance and discoloration caused by light irradiation and heat of the cured product, despite having an aromatic ring due to the styrene backbone, and may exhibit excellent developability and tack-free dryness. The proportion of the styrene backbone may be 10 to 80 mol%, 10 to 60 mol%, or 10 to 50 mol% in the molecule. That is, during synthesis of the carboxyl group-containing resin having a styrene backbone, styrene may be used in an amount of 30 to 60 mol% based on the total amount of monomers. When the proportion of the styrene backbone is 10 mol% or more in the molecule, compatibility with other components is improved, and when it is 80 mol% or less, developability may be improved.

The carboxyl group-containing resin having a styrene backbone may be prepared by suspension polymerization, which may yield a high-molecular-weight resin. As a result, the photosensitive resin composition using such a resin may exhibit excellent tack-free dryness. In general, when the carboxyl group-containing resin having a styrene backbone is prepared by suspension polymerization, the molecular weight tends to be high; however, in consideration of screen-printing suitability, tack-free dryness, and developability, the weight-average molecular weight may be limited to a range of

10,000 to 50,000 g/mol. Accordingly, a chain transfer agent may be used to control the molecular weight during synthesis of the carboxyl group-containing resin having a styrene backbone.

In addition, a polymerization initiator may be used during synthesis of the carboxyl group-containing resin having a styrene backbone to promote polymerization. Examples of the polymerization initiator include BPO (benzoyl peroxide), t-butyl peroxy-2-ethylhexanoate, and AMBN (2,2'-azobis(2-methylbutyronitrile)), and may be, for example, BPO (benzoyl peroxide). The amount of the polymerization initiator may be 0.1 to 10 wt%, or 0.1 to 6 wt%, based on 100 wt% of the carboxyl group-containing resin having a styrene backbone, calculated on a solid content basis.

In the photosensitive resin composition of the present disclosure, the content of the thermally curable acid-value resin may be 0.1 to 15 wt%, 1 to 10 wt%, or 2 to 6 wt%, based on the total weight of the composition. The photosensitive resin composition includes solids and a solvent.

When the content of the thermally curable acid-value resin falls within the above range, reduction in reflectance and discoloration are suppressed, and developability and tack-free dryness are excellent, thereby improving reflectance enhancement effects and yellowing prevention effects.

For example, the thermally curable acid-value resin may be used in a composition for a white solder resist.

[Silane Coupling Agent]

The photosensitive resin composition according to an embodiment of the present disclosure may further comprise a silane coupling agent. By including the silane coupling agent, the photosensitive resin composition may exhibit improved crack resistance, enhanced reflectance compared to conventional compositions, and superior gloss.

The silane coupling agent of the present disclosure may include one having an organic functional group such as a vinyl group, styryl group, acrylic group, methacryl group, isocyanurate group, acid anhydride group, ureido group, epoxy group, amino group, methacryloxy group, mercapto group, isocyanate group, or isocyanurate group.

Examples of silane coupling agents having a vinyl group include vinyltrimethoxysilane and vinyltriethoxysilane. Examples of silane coupling agents having a styryl group include p-styryl methoxysilane. Examples of silane coupling agents having a methacryl group include 3-methacryloxypropylmethyldimethoxysilane, 3-methacryloxypropyltrimethoxysilane, 3-methacryloxypropyldiethoxysilane, and 3-methacryloxypropyltriethoxysilane. Examples of silane coupling agents having an acrylic group include 3-acryloxypropyltrimethoxysilane. Examples of silane coupling agents having an amino group include N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethylbutylidene)propylamine, N-phenyl-3-aminopropyltrimethoxysilane, and N-(vinylbenzyl)-2-aminoethyl-3-aminopropyltrimethoxysilane. Examples of silane coupling agents having a methacryloxy group include 3-methacryloxypropyltrimethoxysilane and 3-methacryloxypropyltriethoxysilane. Examples of silane coupling agents having a mercapto group include 3-mercaptopropylmethyldimethoxysilane and 3-mercaptopropyltrimethoxysilane. Examples of silane coupling agents having an isocyanate group include 3-isocyanatepropyltriethoxysilane. Examples of silane coupling agents having an isocyanurate group include tris-(trimethoxysilylpropyl)isocyanurate. Examples of silane coupling agents having a ureido group include 3-ureidopropyltrialkoxysilane. Examples of silane coupling agents having an acid anhydride group include 3-(trimethoxysilyl)propyl succinic anhydride.

The silane coupling agent may be a silane coupling agent having an epoxy group. Examples thereof include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, and 3-glycidoxypropyltriethoxysilane, and for example, 3-glycidoxypropyltriethoxysilane.

In the photosensitive resin composition of the present disclosure, the content of the silane coupling agent may be 0.1 to 5 wt%, 0.3 to 3 wt%, or 0.4 to 2 wt%, based on the total weight of the composition. The composition includes solid components and a solvent.

When the content of the silane coupling agent is within the above range, the composition may exhibit excellent crack resistance, high reflectance, excellent adhesion, and low tackiness, making it suitable for film formation.

The silane coupling agent may be a commercially available product. Examples thereof include KBM-1003, KBE-1003, KBM-303, KBM-402, KBM-403, KBE-402, KBE-403, KBM-1403, KBM-502, KBM-503, KBE-502, KBE-503, KBM-5103, KBM-602, KBM-603, KBM-903, KBE-903, KBE-9103P, KBM-573, KBM-575, KBM-9659, KBM-585A, KBM-802, KBM-803, KBE-9007N, and X-12-967C, manufactured by Shin-Etsu Chemical Co., Ltd.

For example, the silane coupling agent may be used in a composition for a white solder resist.

[Resin Having Urethane Bond]

The photosensitive resin composition according to an embodiment of the present disclosure may further include a resin having a urethane bond. The resin having a urethane bond may be a resin having excellent flexible properties.

By using the resin having a urethane bond, the photosensitive resin composition may enable lamination with a

uniform thickness without cracking even on a flexible substrate or a thin sheet, and may exhibit excellent resistance to cracking or breakage under external impact or bending.

The resin having a urethane bond of the present disclosure may include a modified urethane resin, and the resin having a urethane bond may be, for example, an ester-type urethane-based resin, an ether-type urethane-based resin, a modified urethane acrylate-based resin, a modified urethane epoxy resin, a silicone-modified urethane resin, a fluorine-based modified urethane resin, or the like, and may be, for example, an epoxy group-containing modified urethane epoxy acrylate.

As the resin having a urethane bond of the present disclosure, known compounds having a urethane bond may be used. Examples thereof include reaction products of an isocyanate compound (e.g., monoisocyanate, diisocyanate, or polyisocyanate) and a compound having an OH group (e.g., a monohydric alcohol, a polyhydric alcohol such as a polyester polyol or polyether polyol, or an epoxy (meth)acrylate), or modified products thereof.

The resin having a urethane bond of the present disclosure may have a carboxyl group or an epoxy group, or may have a (meth)acryloyl group. For example, it may be one of the following carboxyl group-containing resins (1), epoxy group-containing resins (2), or (meth)acryloyl group-containing resins (3), (4), and (5).

(1) A carboxyl group-containing photosensitive polyurethane resin obtained by a medium-addition reaction of a carboxyl group-containing dialcohol compound and a diol compound with (i) a reaction product, a partial anhydride thereof, or a modified product thereof, of a diisocyanate and (ii) a difunctional epoxy resin such as a bisphenol A-type epoxy resin, a hydrogenated bisphenol A-type epoxy resin, a bisphenol F-type epoxy resin, a bisphenol S-type epoxy resin, a bisphenol epoxy resin, or a phenolic epoxy resin, and a monocarboxylic acid compound having an ethylenically unsaturated double bond such as (meth)acrylate.

(2) A urethane-modified epoxy resin having a urethane bond and two or more epoxy groups in the molecule, obtained by reacting (i) a urethane bond-containing compound having an isocyanate group, obtained by reacting a polyhydroxy compound with a polyisocyanate compound, with (ii) a hydroxy group-containing epoxy compound.

(3) A urethane resin obtained by a medium-addition reaction of a diisocyanate such as an aliphatic diisocyanate, a branched aliphatic diisocyanate, an alicyclic diisocyanate, or an aromatic diisocyanate, with a diol compound such as a polycarbonate-based polyol, a polyether-based polyol, a polyester-based polyol, a polyolefin polyol, an acrylic polyol, a hydroxy group-containing epoxy resin (whereby a urethane resin having an epoxy group may be obtained), a bisphenol A-based alkylene oxide adduct diol, or a compound having a phenolic hydroxyl group and an alcoholic hydroxyl group.

(4) A photosensitive polyurethane resin obtained by a medium-addition reaction of such an isocyanate and the diol compound, wherein, in (3), a part or all of the diisocyanate is replaced with a reaction product of isophorone diisocyanate and pentaerythritol triacrylate and/or a compound having one isocyanate group and one or more (meth) acryloyl groups in the molecule.

(5) A terminal (meth)acrylated photosensitive polyurethane resin obtained by additionally adding, during the synthesis of a resin according to (3) or (4), a compound having one hydroxyl group and one or more (meth)acryloyl groups in the molecule, such as hydroxyalkyl (meth)acrylate.

In addition, as described above, one resin may have at least two selected from the group consisting of a carboxyl group, an epoxy group, and a (meth)acryloyl group.

The resin having a urethane bond may be (1) among the carboxyl group-containing resins, may be (2) among the epoxy group-containing resins, or may be (5) among the (meth)acryloyl group-containing resins.

The diisocyanate may be, for example, an aromatic polyisocyanate, an aliphatic polyisocyanate, or an alicyclic polyisocyanate. The aromatic polyisocyanate may be, for example, 4,4'-diphenylmethane diisocyanate, 2,4-diisocyanate-2,6-tolylene diisocyanate, naphthalene-1,5-diisocyanate, o-xylylene diisocyanate, m-xylylene diisocyanate, or a 2,4-tolylene dimer. The aliphatic polyisocyanate may be, for example, tetramethylene diisocyanate, hexamethylene diisocyanate, methylene diisocyanate, trimethylhexamethylene diisocyanate, 4,4-methylenebis(cyclohexyl isocyanate), or isophorone diisocyanate. The alicyclic polyisocyanate may be, for example, bicycloheptane triisocyanate. For example, the diisocyanate may be an aliphatic isocyanate.

When the resin having a urethane bond is a urethane bond-containing carboxyl group-containing resin, the acid value of the carboxyl group-containing resin may be 40 to 200 mgKOH/g, or 45 to 120 mgKOH/g. When the acid value falls within the range of 40 to 200 mgKOH/g, adhesion of the cured film may be ensured and alkali development may be facilitated; thus, dissolution of the exposed portion by the developer is suppressed, so that the line is not narrowed more than necessary and a normal resist pattern may be easily formed.

When the resin having a urethane bond is a urethane bond-containing carboxyl group-containing resin, the weight-average molecular weight of the carboxyl group-containing resin may vary depending on the resin backbone, but may be 2,000 to 150,000 g/mol, 5,000 to 50,000 g/mol, or 2,000 to 50,000 g/mol. When the weight-average molecular weight falls within the above range, tack-free dryness is improved, moisture resistance of the cured film is enhanced, and

reduction in film thickness during development may be reduced. In addition, when the weight-average molecular weight falls within the above range, resolution and developability are favorable, and storage stability may be improved.

Examples of commercially available products of the resin having a urethane bond (e.g., a urethane bond-containing carboxyl group-containing resin) include UXE-3000, UXE-3002, UXE-3024, UXE-3086, UXE-3044, UXE-3061, UXE-3063, UXE-3064, UXE-3065, and UXE-3067 (Nippon Kayaku Co., Ltd.), EPU-7N (urethane-modified epoxy resin; ADEKA Corporation), and Ebecryl 210 (aromatic urethane acrylate; Daicel-Allnex Ltd.).

In the photosensitive resin composition of the present disclosure, the content of the resin having a urethane bond may be 0.1 to 15 wt%, 5 to 13 wt%, or 8 to 12 wt%, based on the total composition. The composition includes solids and a solvent. When the content of the resin having a urethane bond falls within the above range, the flexibility and crack resistance of the composition are excellent, and appropriate tackiness and excellent printability and dryability may be achieved.

The weight-average molecular weight of the resin having a urethane bond in the photosensitive resin composition of the present disclosure may be 2,000 to 150,000 g/mol, or 2,000 to 50,000 g/mol. When the weight-average molecular weight falls within the above range, excellent crack resistance and flexibility may be obtained.

For example, the resin having a urethane bond may be used in a composition for a white solder resist.

[Other Optional Components]

The photosensitive resin composition of the present disclosure may, as needed, further include various additives as optional components. Specifically, a thermosetting catalyst, a dispersant, an antioxidant, a colorant, an epoxy resin, an oxetane compound, a (meth)acrylic resin, other various additives, or a mixture of two or more thereof may be added. As optional components, one or more of the materials described below may be included.

<Epoxy Resin>

As the epoxy resin of the present disclosure, any known and commonly used compound having one or more epoxy groups may be used. For example, the epoxy resin may be one that does not overlap with the above-described components (A) to (G). For example, it may be a compound having two or more epoxy groups. Examples include monoepoxy compounds such as butyl glycidyl ether, phenyl glycidyl ether, and glycidyl (meth)acrylate; and compounds having two or more epoxy groups in one molecule, such as bisphenol A-type epoxy resins, bisphenol S-type epoxy resins, bisphenol F-type epoxy resins, phenol novolac-type epoxy resins, cresol novolac-type epoxy resins, alicyclic epoxy resins, trimethylolpropane polyglycidyl ether, phenyl-1,3-diglycidyl ether, biphenyl-4,4'-diglycidyl ether, 1,6-hexanediol diglycidyl ether, diglycidyl ethers of ethylene glycol or propylene glycol, sorbitol polyglycidyl ether, tris(2,3-epoxypropyl) isocyanurate, and triglycidyl tris(2-hydroxyethyl)isocyanurate. These may be used alone or in combination of two or more, depending on required properties.

Examples of compounds having two or more epoxy groups include, but are not limited to: bisphenol A-type epoxy resins such as jER828, jER834, jER1001, and jER1004 (Mitsubishi Chemical Corporation); Epiklon 840, Epiklon 850, Epiklon 1050, and Epiklon 2055 (DIC Corporation); Epotohto D-011, YD-013, YD-127, and YD-128 (Nippon Steel Chemical & Material Co., Ltd.); D.E.R.317, D.E.R.331, D.E.R.661, and D.E.R.664 (Dow Chemical Japan); Sumiepoxy ESA-011, ESA-014, ELA-115, and ELA-128 (Sumitomo Chemical Co., Ltd.); and A.E.R.330, A.E.R.331, A.E.R.661, and A.E.R.664 (Asahi Kasei Materials Corporation) (all trade names). Also included are brominated epoxy resins such as jERYL903 (Mitsubishi Chemical Corporation); Epiklon 152 and Epiklon 165 (DIC Corporation); Epotohto YDE-400 and YDE-500 (Nippon Steel Chemical & Material Co., Ltd.); D.E.R.542 (Dow Chemical Japan); Sumiepoxy ESB-400 and ESB-700 (Sumitomo Chemical Co., Ltd.); and A.E.R.711 and A.E.R.714 (Asahi Kasei Materials Corporation) (all trade names). Further examples include novolac-type epoxy resins such as jER152 and jER154 (Mitsubishi Chemical Corporation); D.E.N.431 and D.E.N.438 (Dow Chemical Japan); Epiklon N-730, Epiklon N-770, Epiklon N-865, Epiklon N-680, N-690, and N-695 (DIC Corporation) (all trade names); Epotohto YDC-701, YDC-704, YDCN-700-2, YDCN-700-3, YDCN-700-5, YDCN-700-7, YDCN-700-10, YDCN-704, and YDCN-704A (Nippon Steel Chemical & Material Co., Ltd.); EPPN-201, EPPN-1025, EPPN-1020, EPPN-104S, RE-306, and NC-3000 (Nippon Chemical Industrial Co., Ltd.); Sumiepoxy ESCN-195X and ESCN-220 (Sumitomo Chemical Co., Ltd.); and A.E.R.ECN-235 and ECN-299 (Asahi Kasei Materials Corporation) (all trade names). Also included are bisphenol F-type epoxy resins such as Epiklon 830 (DIC Corporation), jER807 (Mitsubishi Chemical Corporation), and Epotohto YDF-175 and YDF-2004 (Nippon Steel Chemical & Material Co., Ltd.) (all trade names); hydrogenated bisphenol A-type epoxy resins such as Epotohto ST-2004, ST-2007, and ST-3000 (Nippon Steel Chemical & Material Co., Ltd.); glycidylamine-type epoxy resins such as jER604 (Mitsubishi Chemical Corporation), Epotohto YH-434 (Nippon Steel Chemical & Material Co., Ltd.), and Sumiepoxy ELM-120 (Sumitomo Chemical Co., Ltd.) (all trade names); hydantoin-type epoxy resins; alicyclic epoxy resins such as CELLOXIDE 2021 (Daicel Corporation) (all trade names); trihydroxyphenylmethane-type epoxy resins such as YL-933 (Mitsubishi Chemical Corporation) and T.E.N., EPPN-501, and EPPN-502 (Dow Chemical Japan) (all trade names); bixylenol-type or

biphenol-type epoxy resins such as YL-6056, YX-4000, and YL-6121 (Mitsubishi Chemical Corporation) (all trade names) or a mixture thereof); bisphenol S-type epoxy resins such as EBPS-200 (Nippon Kayaku Co., Ltd.), EPX-30 (ADEKA Corporation), and EXA-1514 (DIC Corporation); bisphenol A novolac-type epoxy resins such as jER157S (trade name) (Mitsubishi Chemical Corporation); tetraphenylethane-type epoxy resins such as jER YL-931 (trade name) (Mitsubishi Chemical Corporation); heterocyclic epoxy resins such as TEPIC (trade name) (Nissan Chemical Corporation); diglycidyl phthalate resins such as Brenmer DGT (Nitchitsu Co., Ltd.); tetraglycidyl xylenol ethane resins such as ZX-1063 (Nippon Steel Chemical & Material Co., Ltd.); naphthalene group-containing epoxy resins such as ESN-190 and ESN-360 (Nippon Steel Chemical & Material Co., Ltd.) and HP-4032, EXA-4750, and EXA-4700 (DIC Corporation); epoxy resins having a dicyclopentadiene skeleton such as HP-7200 and HP-7200H (DIC Corporation); glycidyl methacrylate copolymer epoxy resins such as CP-50S and CP-50M (Nitchitsu Co., Ltd.); copolymer epoxy resins of cyclohexylmaleimide and glycidyl methacrylate; and CTBN-modified epoxy resins such as YR-102 and YR-450 (Nippon Steel Chemical & Material Co., Ltd.), without limitation. Among these, for example, epoxy resins excellent in resistance to discoloration, such as bisphenol A-type epoxy resins, heterocyclic epoxy resins, or mixtures thereof, may be preferred. These epoxy resins may be used alone or in combination of two or more.

In the photosensitive resin composition of the present disclosure, the epoxy resin may be a bisphenol-based epoxy resin, for example, a bisphenol-based epoxy resin having two or more epoxy groups. The amount of the bisphenol-based epoxy resin having two or more epoxy groups used in the present disclosure may be 1 to 15 wt%, 1 to 12 wt%, or 3 to 12 wt%, based on the total composition. The composition includes solids and a solvent.

When the content of the epoxy resin falls within the above range, the adhesion, heat resistance, and pencil hardness of the coating film formed from the composition are excellent, curing proceeds well, and problems such as yellowing and difficulty in achieving high reflectance after processing may be resolved.

In the photosensitive resin composition of the present disclosure, the weight-average molecular weight of the epoxy resin may be 150 to 100,000 g/mol.

<Oxetane Compound>

Next, oxetane compounds will be described. Specific examples of oxetane compounds containing an oxetane ring represented by the following general formula (I) include 3-ethyl-3-hydroxymethyloxetane (Dong-A Composition Co., Ltd., trade name: OXT-101), 3-ethyl-3-(phenoxymethyl)oxetane (Dong-A Composition Co., Ltd., trade name: OXT-211), 3-ethyl-3-(2-ethylhexyloxymethyl)oxetane (Dong-A Composition Co., Ltd., trade name: OXT-212), 1,4-bis{[(3-ethyl-3-oxetanyl)methoxy]methyl}benzene (Dong-A Composition Co., Ltd., trade name: OXT-121), bis(3-ethyl-3-oxetanylmethyl) ether (Dong-A Composition Co., Ltd., trade name: OXT-221), and the like:

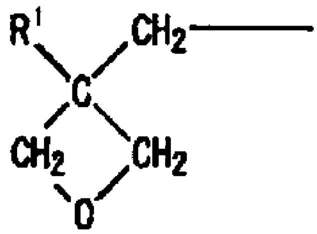

...... (I)

(wherein $R^1$ represents a hydrogen atom or an alkyl group of 1 to 6 carbon atoms). In addition, phenol novolac-type oxetane compounds may also be used. These oxetane compounds may be used in combination with the epoxy compounds described above, or may be used alone.

<(Meth)acrylic Resin>

The (meth)acrylic resin is a photocurable resin. The photocurable resin is not particularly limited as long as it is a resin that is cured by irradiation with active energy rays to exhibit electrical insulating properties, and may be, for example, a compound having one or more ethylenically unsaturated bonds in the molecule. For example, the (meth)acrylic resin may be one that does not overlap with the above-described components (A) to (G).

The compound having an ethylenically unsaturated bond may be a known and commonly used photopolymerizable oligomer, photopolymerizable monomer, or photopolymerizable vinyl monomer. Examples of photopolymerizable oligomers include unsaturated polyester-based oligomers and (meth)acrylate-based oligomers. The (meth)acrylate-based oligomers may include epoxy (meth)acrylates such as phenol novolac epoxy (meth)acrylate, cresol novolac epoxy (meth)acrylate, and bisphenol-type epoxy (meth)acrylate; urethane (meth)acrylate; epoxy urethane (meth)acrylate; polyester (meth)acrylate; polyether (meth)acrylate; and polybutadiene-modified (meth)acrylate.

Examples of photopolymerizable monomers or photopolymerizable vinyl monomers include known and commonly used compounds, such as styrene derivatives including styrene, chlorostyrene, and α-methylstyrene; vinyl esters such as vinyl acetate, vinyl butyrate, and vinyl benzoate; ethers such as vinyl isobutyl ether, vinyl-n-butyl ether, vinyl-t-butyl ether, vinyl-n-amyl ether, vinyl isoamyl ether, vinyl-n-octadecyl ether, vinyl cyclohexyl ether, ethylene glycol monobutyl ether, and triethylene glycol monomethyl ether; (meth)acrylamides such as acrylamide, methacrylamide, N-hydroxymethyl acrylamide, N-hydroxymethyl methacrylamide, N-methoxymethyl acrylamide, N-ethoxymethyl acrylamide, and N-butoxymethyl acrylamide; aryl compounds such as triallyl isocyanurate, diallyl phthalate, and diallyl isophthalate; (meth)acrylic acid esters such as 2-ethylhexyl (meth)acrylate, lauryl (meth)acrylate, tetrahydrofurfuryl (meth)acrylate, isobornyl (meth)acrylate, phenyl (meth)acrylate, and phenoxyethyl (meth)acrylate; hydroxyalkyl (meth)acrylates such as hydroxyethyl (meth)acrylate, hydroxypropyl (meth)acrylate, and pentaerythritol tri(meth)acrylate; alkoxyalkylene glycol mono(meth)acrylates such as methoxyethyl (meth)acrylate and ethoxyethyl (meth)acrylate; alkylene polyol poly(meth)acrylates such as ethylene glycol di(meth)acrylate, butanediol di(meth)acrylate, neopentyl glycol di(meth) acrylate, 1,6-hexanediol di(meth)acrylate, trimethylolpropane tri(meth)acrylate, pentaerythritol tetra(meth)acrylate, and dipentaerythritol hexa(meth)acrylate; polyoxyalkylene glycol poly(meth)acrylates such as diethylene glycol di(meth) acrylate, triethylene glycol di(meth)acrylate, ethoxylated trimethylolpropane triacrylate, and propoxylated trimethylolpropane tri(meth)acrylate; poly(meth)acrylates such as hydroxypivalic acid neopentyl glycol ester di(meth)acrylate; and isocyanurate-type poly(meth)acrylates such as tris[(meth)acryloxyethyl]isocyanurate. These may be used alone or in combination of two or more.

In the photosensitive resin composition of the present disclosure, the (meth)acrylic resin may be an unsaturated polyester-based oligomer or a (meth)acrylate-based oligomer, and may be, for example, a hexafunctional flexible acrylic oligomer. The content of the (meth)acrylic resin may be 1 to 15 wt%, 1 to 10 wt%, or 5 to 10 wt%, based on the total composition. The composition includes solids and a solvent. When the content of the (meth)acrylic resin falls within the above range, resolution and undercut characteristics are excellent, and the coating film can be cured to an appropriate degree.

<Thermal Curing Catalyst>

In the composition of the present disclosure, at least one of a curing agent or a curing catalyst may be further added as a thermal curing catalyst. For example, the thermal curing catalyst may be one that does not overlap with the components described above.

The curing agent may include, for example, polyfunctional phenolic compounds, polycarboxylic acids and acid anhydrides thereof, aliphatic or aromatic primary or secondary amines, polyamide resins, isocyanate compounds, polymeric mercapto compounds, and the like. For example, the curing agent may be a polyfunctional phenolic compound, a polycarboxylic acid, or an acid anhydride thereof, by which excellent workability and insulating properties can be obtained. The polyfunctional phenolic compound is not particularly limited as long as it is a compound having two or more phenolic hydroxyl groups in one molecule, and may be, for example, a known and commonly used compound. Examples thereof include phenol novolac resins, cresol novolac resins, bisphenol A, allylated bisphenol A, bisphenol F, novolac resins of bisphenol A, and vinylphenol copolymer resins. For example, the polyfunctional phenolic compound may be bisphenol A, which enables high reactivity and improved heat resistance. The polyfunctional phenolic compound can undergo an addition reaction with at least one of an epoxy compound or an oxetane compound in the presence of an appropriate curing catalyst. The polycarboxylic acid and the acid anhydride thereof may be, for example, a compound having two or more carboxyl groups in one molecule and an acid anhydride thereof, such as a copolymer of (meth)acrylic acid, a copolymer of maleic anhydride, or a condensate of a dibasic acid. Commercial products include Joncryl® (trade name series) manufactured by BASF, SMA resins (trade name series) manufactured by Sartomer, and polyazelaic anhydride manufactured by Shin-Nippon Rika Co., Ltd.

The curing catalyst may be a compound that functions as a curing catalyst for the reaction between a thermosetting resin such as an epoxy compound or an oxetane compound and a curing agent, or a compound that functions as a polymerization catalyst when a curing agent is not used. Specific examples of the curing catalyst include tertiary amines, tertiary amine salts, quaternary ammonium salts, tertiary phosphines, crown ether compounds, phosphonium ylides, and the like, which may be used alone or in combination of two or more thereof.

Examples include imidazoles such as trade names 2E4MZ, C11Z, C17Z, and 2PZ; imidazole azine compounds such as trade names 2MZ-A and 2E4MZ-A; imidazole isocyanurates such as trade names 2MZ-OK and 2PZ-OK; imidazole hydroxymethyl compounds such as trade names 2PHZ and 2P4MHZ (manufactured by Shikoku Chemicals Corporation); dicyandiamide and derivatives thereof; melamine and derivatives thereof; diaminomaleonitrile and derivatives thereof; amines such as diethylenetriamine, triethylenetetramine, tetraethylenepentamine, bis(hexamethylene) triamine, triethanolamine, and diaminodiphenylmethane; 1,8-diazabicyclo[5.4.0]undec-7-ene (trade name DBU, San-Apro Ltd.); 3,9-bis(3-aminopropyl)-2,4,8,10-tetraoxaspiro[5,5]undecane (trade name ATU, Ajinomoto Co., Inc.); and organic phosphine compounds such as triphenylphosphine, tricyclohexylphosphine, tributylphosphine, and methyldiphenylphosphine.

In the photosensitive resin composition of the present disclosure, the curing catalyst may be an amine-based, phosphine-based, or imidazole-based curing catalyst, and for example, may be a melamine-based amine curing catalyst. The content of the curing catalyst may be 0.1 to 15 wt%, 0.1 to 10 wt%, or 0.1 to 3 wt%, based on the total composition.

When the content of the curing catalyst falls within the above range, the coating film is sufficiently cured, thereby exhibiting excellent adhesion, pencil hardness, and heat resistance, while maintaining an appropriate curing time and preventing deterioration in developability.

<Antioxidant>

The photosensitive resin composition of the present disclosure may further contain an antioxidant. By containing an antioxidant, it is possible not only to obtain the effect of suppressing discoloration by preventing oxidative degradation of a curable resin or the like, but also to improve heat resistance and achieve favorable resolution (reproducibility of line width). That is, depending on the type of white colorant, light reflection and absorption may deteriorate resolution; however, by containing an antioxidant, good resolution can be obtained regardless of the type of white colorant. The antioxidant may be a radical scavenger that deactivates generated radicals, a peroxide decomposition inhibitor that decomposes generated peroxides into harmless substances and prevents the generation of new radicals, or the like, and may be used alone or in a combination of two or more.

Examples of antioxidants effective as radical scavengers include phenolic compounds such as hydroquinone, 4-t-butylcatechol, 2-t-butylhydroquinone, hydroquinone monomethyl ether, 2,6-di-t-butyl-p-cresol, 2,2-methylene-bis(4-methyl-6-t-butylphenol), 1,1,3-tris(2-methyl-4-hydroxy-5-t-butylphenyl)butane, 1,3,5-trimethyl-2,4,6-tris(3,5-di-t-butyl-4-hydroxybenzyl)benzene, and 1,3,5-tris(3',5'-di-t-butyl-4-hydroxybenzyl)-S-triazine-2,4,6-(1H,3H,5H)-trione; quinone compounds such as menaquinone and benzoquinone; and amine compounds such as bis(2,2,6,6-tetramethyl-4-piperidyl) sebacate and phenothiazine. Commercial products include, for example, IRGANOX® 1010 (manufactured by BASF Japan Ltd.; trade name).

Examples of antioxidants effective as peroxide decomposition inhibitors include phosphorus-based compounds such as triphenyl phosphite, and sulfur-based compounds such as pentaerythritol tetralaurylthiopropionate, dilauryl thiodipropionate, and distearyl-3,3'-thiodipropionate.

For example, the antioxidant may be a phenolic compound, and when used, effects such as suppression of discoloration, improvement of heat resistance, and reproduction of even better resolution can be achieved.

The antioxidant, for example a phenolic antioxidant, may be used in combination with a heat stabilizer. When used in combination, more excellent effects can be obtained.

The heat stabilizer may be, for example, a phosphorus-based, hydroxylamine-based, or sulfur-based heat stabilizer. The heat stabilizer may be used alone or in a combination of two or more.

For example, the antioxidant may be a hydroxylamine-based antioxidant and a sulfur-based antioxidant, or a phenolic antioxidant. When a phenolic antioxidant is used, the amount thereof may be 0.01 to 5 wt%, or 0.03 to 3 wt%, based on the total composition. By setting the amount of the antioxidant to 0.01 wt% or more, the effect of adding the antioxidant can be reliably obtained; and by setting it to 1 wt% or less, it is possible to obtain favorable alkaline developability without inhibiting the photoreaction, while also maintaining favorable tack-free drying properties and coating film properties.

<Organic Solvent>

The photosensitive resin composition of the present disclosure may contain an organic solvent for purposes such as preparation of the composition and adjustment of viscosity during coating onto a substrate or base material. As the organic solvent, commonly known and conventionally used organic solvents may be employed, including esters; aliphatic hydrocarbons such as octane and decane; petroleum-based solvents such as petroleum ether, petroleum naphtha, and solvent naphtha; and the like. These organic solvents may be used alone or in a combination of two or more.

<Colorant>

The photosensitive resin composition of the present disclosure may contain a colorant.

The colorant may include one or more selected from blue colorants, green colorants, yellow colorants, white colorants, black colorants, and red colorants, either alone or in an appropriate combination of two or more thereof. Any of pigments, dyes, or colorants may be used. In the present disclosure, a "pigment" refers to a compound classified as a pigment in the Color Index (C.I.; published by The Society of Dyers and Colourists), and a "dye" refers to a compound classified as other than a solvent dye or a lumogen (registered trademark). From the viewpoints of reducing environmental burden and minimizing effects on the human body, colorants that do not contain halogens are preferred.

(1) Blue colorants include metal-substituted or non-substituted phthalocyanine compounds and anthraquinone-based compounds. Pigment-based examples include compounds classified as pigments and assigned the following Color Index numbers: Pigment Blue 15, 15:1, 15:2, 15:3, 15:4, 15:6, 16, and 60. Dye-based examples include Solvent Blue 35, 63, 68, 70, 83, 87, 94, 97, 122, 136, 67, and 70.
(2) Green colorants include metal-substituted or non-substituted phthalocyanine-based compounds, anthraquinone-based compounds, and perylene-based compounds. Specific examples include Pigment Green 7, Pigment Green 36, Solvent Green 3, Solvent Green 20, and Solvent Green 28.
(3) Yellow colorants include anthraquinone-based, isoindolinone-based, condensed azo-based, benzimidazolone-based, monoazo-based, and disazo-based compounds. Specific examples include the following: (anthraquinone-based) Solvent Yellow 163; Pigment Yellow 24, 108, 193, 147, 199, and 202; (isoindolinone-based) Pigment Yellow 110, 109, 139, 179, and 185; (condensed azo-based) Pigment Yellow 93, 94, 95, 128, 155, 166, and 180; (benzimidazolone-based) Pigment Yellow 120, 151, 154, 156, 175, and 181; (monoazo-based) Pigment Yellow 1, 2, 3, 4, 5, 6, 9, 10, 12, 61, 62, 62:1, 65, 73, 74, 75, 97, 100, 104, 105, 111, 116, 167, 168, 169, 182, and 183; (disazo-based) Pigment Yellow 12, 13, 14, 16, 17, 55, 63, 81, 83, 87, 126, 127, 152, 170, 172, 174, 176, 188, and 198.
(4) Black colorants include titanium black-based, carbon black-based, graphite-based, iron oxide-based, anthraquinone-based, cobalt oxide-based, copper oxide-based, manganese-based, antimony oxide-based, nickel oxide-based, perylene-based, and aniline-based pigments, as well as molybdenum sulfide and bismuth sulfide.
(5) Red colorants include monoazo-based, disazo-based, monoazo lake-based, benzimidazolone-based, diketopyrrolopyrrole-based, condensed azo-based, anthraquinone-based, and quinacridone-based compounds. Specific examples include the following:
(monoazo-based) Pigment Red 1, 2, 3, 4, 5, 6, 8, 9, 12, 14, 15, 16, 17, 21, 22, 23, 31, 32, 112, 114, 146, 147, 151, 170, 184, 187, 188, 193, 210, 245, 253, 258, 266, 267, 268, and 269; (disazo-based) Pigment Red 37, 38, and 41; (monoazo lake-based) Pigment Red 48:1, 48:2, 48:3, 48:4, 49:1, 49:2, 50:1, 52:1, 52:2, 53:1, 53:2, 57:1, 58:4, 63:1, 63:2, 64:1, and 68; (benzimidazolone-based) Pigment Red 171, 175, 176, 185, and 208; (diketopyrrolopyrrole-based) Pigment Red 254, 255, 264, 270, and 272; (condensed azo-based) Pigment Red 220, 144, 166, 214, 220, 221, and 242; (anthraquinone-based) Pigment Red 168, 177, and 216; Solvent Red 149, 150, 52, and 207; (quinacridone-based) Pigment Red 122, 202, 206, 207, and 209.

The amount of the colorant in this case may be, based on 100 parts by mass of the total composition, in the range of 0.01 to 7 parts by mass for each of the blue, green, yellow, black, and red colorants, for example, 0.5 to 6 parts by mass, or 1 to 5 parts by mass.

<Dispersant>

A dispersant may be added in order to improve storage stability, coatability, printability, and aggregation resistance of the photosensitive resin composition. The dispersant is not particularly limited, and known dispersants may be used. Examples of the dispersant include phosphate esters and acrylic copolymers having acidic groups and/or basic groups; polyamines; polyurethanes; polyesters; polyacrylates and their phosphates; alkylammonium aliphatic carboxylates; higher alcohol sulfate esters; alkyl sulfonic acids; polyethers; polyester carboxylic acids; copolymers containing acidic groups; pigment-affinitive block copolymers; phosphate ester compounds; polyether phosphate ester compounds; fatty acid ester compounds; alkylene oxide copolymers; modified polyether polymers; and fatty acid derivatives. By including a dispersant, the viscosity of the photosensitive resin composition can be reduced, dispersion of solid particles in the composition is improved, aggregation is suppressed, and coatability and coating performance can be improved. Specific examples include the DISPERBYK® series (BYK, Evonik), the EFKA® series (BASF), the SOLSPERSE® series (Lubrizol Japan), the Disparlon® series (Kusumoto Chemicals), and the Flowlen® series (Kyoeisha Chemical), although the dispersant is not limited thereto. The dispersant may be used alone or in combination of two or more. The content of the dispersant may be, based on the total amount of the composition, 0.5 to 9 wt%, for example, 1 to 7 wt%, or 1 to 5 wt%.

<Other Additives>

In addition, the photosensitive resin composition of the present disclosure may contain other additives commonly used in the field of electronic materials. Examples of such additives include thermal polymerization inhibitors, ultraviolet absorbers, plasticizers, flame retardants, antistatic agents, aging inhibitors, antibacterial and antifungal agents, defoaming agents, leveling agents, thickeners, adhesion promoters, thixotropic agents, photoinitiator assistants, sensitizers, curing accelerators, release agents, surface treatment agents, dispersion aids, surface modifiers, stabilizers, and the like.

[Dry Film and Method for Producing the Same]

Another embodiment of the present disclosure relates to a dry film having a photosensitive resin layer formed by coating and drying a photosensitive resin composition on a first film.

In forming the dry film, first, the composition of the present disclosure is diluted with an organic solvent to adjust the viscosity to an appropriate level, and then coated onto the first film at a uniform thickness, for example, in the range of 40 to 60 μm, by means of a comma coater, blade coater, lip coater, rod coater, squeeze coater, reverse coater, transfer roll coater, gravure coater, micro-gravure coater, spray coater, or the like. Thereafter, the coated composition is dried, typically at a temperature in the range of 40 to 120°C for 1 to 30 minutes, to form a photosensitive resin layer, thereby producing the dry film.

The thickness of the coating film is not particularly limited; however, in general, the thickness after drying may be 10 to 150 μm, 10 to 80 μm, or 10 to 60 μm.

As the first film, a plastic film may be used, and examples thereof include polyester films such as polyethylene terephthalate (PET), polyimide films, polyamide-imide films, polypropylene films, and polystyrene films, and for example, polyethylene terephthalate may be used. The thickness of the first film is not particularly limited, but may generally be appropriately selected within the range of 10 to 150 μm. In addition, coating may be performed on a metal foil such as copper foil or aluminum foil. Further, the first film used may be subjected to a release treatment with acrylic, silicone, or the like.

When the dry film of the present disclosure is white, it may be used to reflect light emitted from light-emitting diodes (LEDs) or electroluminescent (EL) devices, which are used as light sources in backlights of liquid crystal displays for lighting devices, mobile terminals, notebook computers, tablet PCs, monitors, smartphones, personal computers, automotive displays, headlamps, televisions, and the like. The dry film of the present disclosure may be applied to LEDs and light-emitting PCBs.

In addition, the colored (blue, green, black) dry film of the present disclosure may be applied to PCBs or component substrates of electronic devices such as electronic watches, automobiles, medical devices, substrates for credit cards, electronic wristwatches, earphones, smartphones, cameras, camera modules, and micro-LED displays.

In order to fabricate a cured coating film on a printed wiring board using the dry film, a second film for protecting the dry film is peeled off, and the exposed resin layer of the dry film is laminated onto a circuit-formed substrate using a laminator or the like to form a resin layer on the circuit-formed substrate. Subsequently, the formed resin layer is subjected to exposure, development, and curing after heating to form a cured coating film. The second film may be peeled off at any stage either before exposure or after exposure.

[Cured Product and Method for Producing Same]

The cured product of the present disclosure may be formed by curing the photosensitive resin composition of the present disclosure, or a solder resist layer of the dry film of the present disclosure.

The cured product of the present disclosure may be suitably used for printed wiring boards and electronic components. The cured product of the present disclosure may exhibit a high photoreaction rate, low moisture absorption and low water vapor permeability, low ion migration, a low outgas content, and excellent pencil hardness and HAST resistance.

For example, the cured product of the present disclosure may be a white or colored (blue, green, black) solder resist.

The solder resist may be manufactured by a method in which the photosensitive resin composition of the present disclosure is applied onto a substrate to form a photosensitive resin layer, the resin layer is selectively exposed to active energy rays through a photomask having a predetermined pattern, and unexposed portions are developed with a dilute alkaline aqueous solution (for example, a 0.3 to 3 wt% sodium carbonate aqueous solution) to form a pattern. Alternatively, in the case of a dry film, after exposure, a patterned solder resist may be formed on the substrate by peeling off the first film of the dry film and then performing development. Further, as long as the properties are not impaired, the first film may be peeled off from the dry film prior to exposure, and the exposed resin layer may be exposed and developed.

[Printed Wiring Board and Method for Manufacturing Same]

The printed wiring board of the present disclosure may include a cured coating formed by curing the cured product of the photosensitive resin composition of the present disclosure or by curing the photosensitive resin layer of the dry film of the present disclosure.

The printed wiring board of the present disclosure may include a cured product obtained from the photosensitive resin composition of the present disclosure or from the photosensitive resin layer of the dry film. A method for manufacturing the printed wiring board of the present disclosure may include, for example, adjusting the viscosity of

the photosensitive resin composition of the present disclosure to be suitable for a coating method using the organic solvent, applying the composition onto a substrate by a method such as dip coating, flow coating, roll coating, bar coating, screen printing, or curtain coating, and then evaporating and drying (pre-drying) the organic solvent contained in the composition at a temperature of 60 to 100°C to form a tacky-free resin layer. In the case of a dry film, the resin layer may be laminated onto the substrate so as to be in contact with the substrate using a laminator or the like, and then the first film may be peeled off to form the resin layer on the substrate.

Examples of the substrate include not only printed wiring boards and flexible printed wiring boards having circuits formed of copper or the like, but also substrates made of materials such as paper phenolic, paper epoxy, glass fiber epoxy, glass polyimide, glass fiber/epoxy, glass fiber/paper epoxy, synthetic fiber epoxy, and high-frequency circuit copper-clad laminates using fluororesin, polyethylene, polyphenylene ether, or polyphenylene oxide cyanate. Specific examples include FR-4 substrates, copper-clad laminates of all grades (including FR-4), other metal substrates, polyimide films, polyethylene terephthalate films, polyethylene naphthalate (PEN) films, glass substrates, ceramic substrates, and wafer substrates.

As a method of laminating the dry film onto the substrate, vacuum lamination may be performed by applying pressure and heat using a vacuum laminator or the like. By using such a vacuum laminator, even when a circuit-formed substrate has an uneven surface, the dry film can closely adhere to the circuit substrate, thereby preventing the inclusion of air bubbles and improving the mitigation of concave portions on the substrate surface. The pressure condition may be about 0.1 to 2.0 MPa, and the temperature condition may be 40 to 120°C.

Further, the cured product may be finally cured by one of the following methods: i) irradiation with active energy rays followed by heat curing (for example, at 100 to 220°C); ii) heat curing followed by irradiation with active energy rays; iii) irradiation with active energy rays only; or iv) heat curing only, thereby forming a cured film having excellent adhesion, hardness, and other properties.

The cured product of the present disclosure may be cured by heating at a temperature of, for example, 100 to 220°C, thereby forming a cured film having high reflectance, excellent yellowing resistance, excellent crack resistance, and other superior properties.

Examples of an exposure apparatus used for irradiation with active energy rays include apparatuses equipped with a high-pressure mercury lamp, an ultra-high-pressure mercury lamp, a metal halide lamp, or a mercury short-arc lamp, which irradiate ultraviolet (UV) light in a wavelength range of 350 to 450 nm, as well as direct imaging apparatuses (e.g., laser direct imaging apparatuses that directly draw patterns with a laser based on CAD data from a computer). The light source of the direct imaging lamp or laser may have a maximum wavelength in the range of 350 to 450 nm. The exposure dose for image formation may vary depending on the thickness and the like, but is generally 10 to 1,000 mJ/cm2, or 20 to 800 mJ/cm2.

The development method may be a dipping method, shower method, spray method, brush method, or the like, and the developer may be an alkaline aqueous solution such as potassium hydroxide, sodium hydroxide, sodium carbonate, potassium carbonate, sodium phosphate, sodium silicate, ammonia, or amines.

The printed wiring board of the present disclosure may include a dry film including one or more layers formed from the photosensitive resin composition.

When forming the printed wiring board, the dry film may be placed on a test substrate and transferred onto the test substrate by vacuum lamination.

Thereafter, the first film may be peeled off, and the substrate onto which the dry film with the first film removed has been transferred may be subjected to UV exposure using an exposure apparatus. By such exposure, the exposed portions (irradiated portions) may be cured. After exposure, the substrate may be cooled at room temperature and then placed in a developing apparatus to develop the unexposed portions with an alkaline aqueous solution, thereby completing the formation of a resist pattern. The substrate on which the pattern has been formed through development may be finally cured (post-cured) in an oven at 150°C for 1 hour to complete the substrate fabrication. After final curing, a reflow process may be performed, followed by a chip mounting process.

The method for manufacturing a printed wiring board including the cured product of the present disclosure may include, for example, peeling off the first film after performing an exposure step following a lamination process.

## <EXAMPLES>

Hereinafter, the present disclosure will be described in detail with reference to Examples. The present disclosure is not limited to the following Examples.

### Preparation of Photosensitive Resin Compositions

[TABLE 1]

Table 1. Contents of Individual Components of Photosensitive Resin Composition (unit: wt% based on the total weight of composition, rounded to the third decimal place)

| Component | Ex. 1 | Ex. 2 | Ex. 3 | Ex. 4 | Ex. 5 | Ex. 6 | Ex. 7 | Ex. 8 |
|---|---|---|---|---|---|---|---|---|
| (A) Carboxyl group-containing resin | 16.00 | 16.00 | 16.00 | 16.00 | 16.00 | 16.00 | 16.00 | 16.00 |
| (B) Photopolymerization initiator (oxime) | 0.50 | 0.50 | 0.50 | 0.50 | 0.50 | 0.50 | 0.50 | 0.50 |
| (B-1) Photopolymerization initiator TPO | 0.00 | 0.00 | 0.00 | 0.00 | 0.00 | 0.00 | 0.00 | 0.00 |
| (B-2) Photopolymerization initiator TPO-L | 0.00 | 0.00 | 0.00 | 0.00 | 0.00 | 0.00 | 0.00 | 0.00 |
| (B-3) Photopolymerization initiator Omnipol TP | 0.00 | 0.00 | 0.00 | 0.00 | 0.00 | 0.00 | 0.00 | 0.00 |
| (B-4) Photopolymerization initiator TMO | 0.10 | 1.00 | 3.00 | 10.00 | 15.00 | 3.00 | 3.00 | 3.00 |
| (C) Inorganic filler: silica | 2.00 | 2.00 | 2.00 | 2.00 | 2.00 | 2.00 | 2.00 | 2.00 |
| (C) Inorganic filler: TiO2 | 44.90 | 44.00 | 42.00 | 35.00 | 30.00 | 42.50 | 42.00 | 38.00 |
| (D) Epoxy resin | 10.00 | 10.00 | 10.00 | 10.00 | 10.00 | 10.00 | 10.00 | 10.00 |
| (E) Acryl resin | 8.00 | 8.00 | 8.00 | 8.00 | 8.00 | 8.00 | 8.00 | 8.00 |
| (F) Thermosetting catalyst: imidazole | 1.00 | 1.00 | 1.00 | 1.00 | 1.00 | 0.50 | 1.00 | 5.00 |
| (F) Thermosetting catalyst: melamine | 0.00 | 0.00 | 0.00 | 0.00 | 0.00 | 0.00 | 0.00 | 0.00 |
| (F) Thermosetting catalyst: dicyandiamide | 0.00 | 0.00 | 0.00 | 0.00 | 0.00 | 0.00 | 0.00 | 0.00 |
| (G) Dispersant | 1.00 | 1.00 | 1.00 | 1.00 | 1.00 | 1.00 | 1.00 | 1.00 |
| Mercapto-modified acrylate | 2.00 | 2.00 | 2.00 | 2.00 | 2.00 | 2.00 | 2.00 | 2.00 |
| Resin with urethane bond | 8.00 | 8.00 | 8.00 | 8.00 | 8.00 | 8.00 | 8.00 | 8.00 |
| Silane coupling agent | 1.00 | 1.00 | 1.00 | 1.00 | 1.00 | 1.00 | 1.00 | 1.00 |
| Thermosetting acid value resin | 5.00 | 5.00 | 5.00 | 5.00 | 5.00 | 5.00 | 5.00 | 5.00 |
| Antioxidant | J.50 | 0.50 | 0.50 | 0.50 | 0.50 | 0.50 | 0.50 | 0.50 |
| Sum | 100.00 | 100.00 | 100.00 | 100.00 | 100.00 | 100.00 | 100.00 | 100.00 |

| Component | Ex. 9 | C. Ex. 1 | C. Ex. 2 | C. Ex. 3 | C. Ex. 4 | Ex. 5 | C. Ex. 6 | C. Ex. 7 |
|---|---|---|---|---|---|---|---|---|
| (A) Carboxyl group-containing resin | 16.00 | 16.00 | 16.00 | 16.00 | 16.00 | 16.00 | 16.00 | 16.00 |
| (B) Photopolymerization initiator (oxime) | 0.50 | 0.50 | 0.50 | 0.50 | 0.50 | 0.50 | 0.50 | 0.50 |
| (B-1) Photopolymerization initiator TPO | 0.00 | 3.00 | 0.00 | 0.00 | 0.00 | 0.00 | 0.00 | 0.00 |
| (B-2) Photopolymerization initiator TPO-L | 0.00 | 0.00 | 3.00 | 0.00 | 0.00 | 0.00 | 0.00 | 0.00 |
| (B-3) Photopolymerization initiator Omnipol TP | 0.00 | 0.00 | 0.00 | 3.00 | 0.00 | 0.00 | 0.00 | 0.00 |

(continued)

| Component | Ex. 9 | C. Ex. 1 | C. Ex. 2 | C. Ex. 3 | C. Ex. 4 | Ex. 5 | C. Ex. 6 | C. Ex. 7 |
|---|---|---|---|---|---|---|---|---|
| (B-4) Photopolymerization initiator TMO | 3.00 | 0.00 | 0.00 | 0.00 | 0.05 | 3.00 | 3.00 | 3.00 |
| (C) Inorganic filler: silica | 2.00 | 2.00 | 2.00 | 2.00 | 2.00 | 2.00 | 2.00 | 2.00 |
| (C) Inorganic filler: TiO2 | 33.00 | 42.00 | 42.00 | 42.00 | 44.95 | 42.00 | 42.00 | 42.90 |
| (D) Epoxy resin | 10.00 | 10.00 | 10.00 | 10.00 | 10.00 | 10.00 | 10.00 | 10.00 |
| (E) Acryl resin | 8.00 | 8.00 | 8.00 | 8.00 | 8.00 | 8.00 | 8.00 | 8.00 |
| (F) Thermosetting catalyst: imidazole | 10.00 | 1.00 | 1.00 | 1.00 | 1.00 | 0.00 | 0.00 | 0.10 |
| (F) Thermosetting catalyst: melamine | 0.00 | 0.00 | 0.00 | 0.00 | 0.00 | 1.00 | 0.00 | 0.00 |
| (F) Thermosetting catalyst: dicyandiamide | 0.00 | 0.00 | 0.00 | 0.00 | 0.00 | 0.00 | 1.00 | 0.00 |
| (G) Dispersant | 1.00 | 1.00 | 1.00 | 1.00 | 1.00 | 1.00 | 1.00 | 1.00 |
| Mercapto-modified acrylate | 2.00 | 2.00 | 2.00 | 2.00 | 2.00 | 2.00 | 2.00 | 2.00 |
| Resin with urethane bond | 8.00 | 8.00 | 8.00 | 8.00 | 8.00 | 8.00 | 8.00 | 8.00 |
| Silane coupling agent | 1.00 | 1.00 | 1.00 | 1.00 | 1.00 | 1.00 | 1.00 | 1.00 |
| Thermosetting acid value resin | 5.00 | 5.00 | 5.00 | 5.00 | 5.00 | 5.00 | 5.00 | 5.00 |
| Antioxidant | 0.50 | 0.50 | 0.50 | 0.50 | 0.50 | 0.50 | 0.50 | 0.50 |
| Sum | 100.00 | 100.00 | 100.00 | 100.00 | 100.00 | 100.00 | 100.00 | 100.00 |

(A) Carboxyl group-containing resin EPICLON R-2000, manufactured by DIC Corporation: containing cresol novolac (weight average molecular weight: 7,500g/mol, acid value: 54 mg KOH/g, solid content acid value: 84.4 mg KOH/g, solid content 64 wt%)
(B) Photopolymerization initiator (oxime based): oxime ester initiator IRGACURE OXE02, solid state (manufactured by BASF Japan)
(B-1) Photopolymerization initiator: Omnirad TPO, molecular weight: 348.37g/mol. (manufactured by IGM Resins)
(B-2) Photopolymerization initiator: Omnirad TPO L, molecular weight: 316.33g/mol, liquid state. (manufactured by IGM Resins)
(B-3) Photopolymerization initiator: Omnipol TP, average molecular weight: 900g/mol or more, liquid state. (manufactured by IGM Resins)
(B-4) Photopolymerization initiator: SINOCURE 2425, TMO (Sinocure Chemical Group), molecular weight: 376.43g/mol
TMO(Di-p-tolyl(2,4,6-trimethylbenzoyl)phosphine oxide)
(C) TiO2: rutile-type titanium oxide, R-931 manufactured by DuPont
(C) Silica: Admafine SO-E2 (manufactured by Admatechs)
(D) Epoxy resin: jER828(Bisphenol A epoxy resin, manufactured by Mitsubishi Chemical Corporation) epoxy equivalent of solid content: 180, solid content 100%)
(E) Acryl resin: KAYARAD DPCA-60 (manufactured by Nippon Kayaku Co., Ltd.)
(F) Thermosetting catalyst: imidazole (manufactured by Mitsubishi Chemical Corporation)
(F) Thermosetting catalyst: melamine (manufactured by Mitsubishi Chemical Corporation)
(F) Thermosetting catalyst: dicyandiamide (manufactured by Mitsubishi Chemical Corporation)
(G) Dispersant: Disperbyk-110 (manufactured by BYK)
Mercapto-modified acrylate: ES110N (Miwon Specialty Chemical)
Resin having urethane bond: UXE-3000 resin manufactured Nippon Kayaku Co., Ltd.
Silane coupling agent: KBE-403 Shin-Etsu Chemical Co., Ltd.

(continued)

| |
|---|
| Thermosetting acid value resin: VB5301(manufactured by Mitsubishi Rayon Co., Ltd.)<br>Antioxidant: Phenol-based antioxidant IRGANOX1010 (manufactured by BASF Japan) |

[TABLE 2]

Table 2. Contents of Individual Components of Photosensitive Resin Composition (unit: wt% based on the total weight of composition, rounded to the third decimal place)

| Component | Ex. 10 | Ex. 11 | Ex. 12 | Ex. 13 | Ex. 14 | Ex. 15 | Ex. 16 |
|---|---|---|---|---|---|---|---|
| (A) Carboxyl group-containing resin | 40.00 | 40.00 | 40.00 | 40.00 | 40.00 | 40.00 | 40.00 |
| (B) Photopolymerization initiator (oxime) | 0.50 | 0.50 | 0.50 | 0.50 | 0.50 | 0.50 | 0.50 |
| (B-1) Photopolymerization initiator TPO | 0.00 | 0.00 | 0.00 | 0.00 | 0.00 | 0.00 | 0.00 |
| (B-2) Photopolymerization initiator TPO-L | 0.00 | 0.00 | 0.00 | 0.00 | 0.00 | 0.00 | 0.00 |
| (B-3) Photopolymerization initiator Omnipol TP | 0.00 | 0.00 | 0.00 | 0.00 | 0.00 | 0.00 | 0.00 |
| (B-4) Photopolymerization initiator TMO | 0.10 | 3.00 | 10.00 | 15.00 | 3.00 | 3.00 | 3.00 |
| (C) Inorganic filler: silica | 13.90 | 11.00 | 4.00 | 3.00 | 11.00 | 7.00 | 11.90 |
| (C) Inorganic filler: barium sulfate | 21.50 | 21.50 | 21.50 | 17.50 | 21.50 | 21.50 | 21.50 |
| (D) Epoxy resin | 11.00 | 11.00 | 11.00 | 11.00 | 11.00 | 11.00 | 11.00 |
| (E) Acryl resin | 8.00 | 8.00 | 8.00 | 8.00 | 8.00 | 8.00 | 8.00 |
| (F) Thermosetting catalyst: imidazole | 1.00 | 1.00 | 1.00 | 1.00 | 1.00 | 1.00 | 1.00 |
| (G) Dispersant | 1.00 | 1.00 | 1.00 | 1.00 | 1.00 | 5.00 | 0.10 |
| Colorant: black pigment | 3.00 | 3.00 | 3.00 | 3.00 | 0.00 | 0.00 | 0.00 |
| Colorant: blue pigment | 0.00 | 0.00 | 0.00 | 0.00 | 3.00 | 3.00 | 3.00 |
| Colorant: green pigment | 2.00 | 0.00 | 0.00 | 0.00 | J.00 | 0.00 | 0.00 |
| Sum | 100.00 | 100.00 | 100.00 | 100.00 | 100.00 | 100.00 | 100.00 |

| Component | Ex. 17 | Ex. 18 | C. Ex. 8 | C. Ex. 9 | C. Ex. 10 | C. Ex. 11 |
|---|---|---|---|---|---|---|
| (A) Carboxyl group-containing resin | 40.00 | 40.00 | 40.00 | 40.00 | 40.00 | 40.00 |
| (B) Photopolymerization initiator (oxime) | 0.50 | 0.50 | 0.50 | 0.50 | 0.50 | 0.50 |
| (B-1) Photopolymerization initiator TPO | 0.00 | 0.00 | 3.00 | 0.00 | 0.00 | 0.00 |
| (B-2) Photopolymerization initiator TPO-L | 0.00 | 0.00 | 0.00 | 3.00 | 0.00 | 0.00 |
| (B-3) Photopolymerization initiator Omnipol TP | 0.00 | 0.00 | 0.00 | 0.00 | 3.00 | 0.00 |
| (B-4) Photopolymerization initiator TMO | 3.00 | 3.00 | 0.00 | 0.00 | 0.00 | 0.05 |
| (C) Inorganic filler: silica | 12.00 | 11.00 | 11.00 | 11.00 | 11.00 | 13.95 |
| (C) Inorganic filler: barium sulfate | 21.50 | 21.50 | 21.50 | 21.50 | 21.50 | 21.50 |
| (D) Epoxy resin | 11.00 | 11.00 | 11.00 | 11.00 | 11.00 | 11.00 |
| (E) Acryl resin | 8.00 | 8.00 | 8.00 | 8.00 | 8.00 | 8.00 |
| (F) Thermosetting catalyst: imidazole | 1.00 | 1.00 | 1.00 | 1.00 | 1.00 | 1.00 |
| (G) Dispersant | 0.00 | 1.00 | 1.00 | 1.00 | 1.00 | 1.00 |
| Colorant: black pigment | 0.00 | 0.00 | 3.00 | 3.00 | 3.00 | 3.00 |
| Colorant: blue pigment | 3.00 | 0.00 | 0.00 | 0.00 | 0.00 | 0.00 |
| Colorant: green pigment | 0.00 | 3.00 | 0.00 | 0.00 | 0.00 | 0.00 |

(continued)

| Component | Ex. 17 | Ex. 18 | C. Ex. 8 | C. Ex. 9 | C. Ex. 10 | C. Ex. 11 |
|---|---|---|---|---|---|---|
| Sum | 100.00 | 100.00 | 100.00 | 100.00 | 100.00 | 100.00 |

(A) Carboxyl group-containing resin EPICLON R-2000, manufactured by DIC Corporation: containing cresol novolac (weight average molecular weight: 7,500g/mol, acid value: 54 mg KOH/g, solid content acid value: 84.4 mg KOH/g, solid content 64 wt%)
(B) Photopolymerization initiator (oxime based): oxime ester initiator IRGACURE OXE02, solid state (manufactured by BASF Japan)
(B-1) Photopolymerization initiator: Omnirad TPO, molecular weight: 348.37g/mol. (manufactured by IGM Resins)
(B-2) Photopolymerization initiator: Omnirad TPO L, molecular weight: 316.33g/mol, liquid state. (manufactured by IGM Resins)
(B-3) Photopolymerization initiator: Omnipol TP, average molecular weight: 900g/mol or more, liquid state. (manufactured by IGM Resins)
(B-4) Photopolymerization initiator: SINOCURE 2425, TMO, molecular weight: 376.43g/mol TMO Sinocure Chemical Group), TMO(Di-p-tolyl(2,4,6-trimethylbenzoyl)phosphine oxide)
(C) Silica: Admafine SO-E2 (manufactured by Admatechs)
(C) Barium sulfate (Bariace B-30, Sakai Chemical)
(D) Epoxy resin: jER828(Bisphenol A epoxy resin, manufactured by Mitsubishi Chemical Corporation) epoxy equivalent of solid content: 180, solid content 100%)
(E) Acryl resin: KAYARAD DPCA-60 (manufactured by Nippon Kayaku Co., Ltd.)
(F) Thermosetting catalyst: imidazole (manufactured by Mitsubishi Chemical Corporation)
(G) Dispersant: Disperbyk-110 (manufactured by BYK)
Colorant(black pigment): Carbon black (MA-100, Mitsubishi Chemical Corporation)
Colorant(blue pigment): phthalocyanine blue, Heliogen Blue D 7088 (BASF)
Colorant(green pigment): FASTOGEN GREEN FS, (DIC Corporation)

## Preparation of Dry Films of Photosensitive Resin Compositions

In a clean room, using a comma coater apparatus, (1) each of the compositions of the Examples and Comparative Examples was applied at a uniform thickness (60 μm) onto a first film (PET film) (XD-500P manufactured by Toray Industries, Inc.; film thickness: 25 μm). (2) The applied compositions were dried in four temperature chambers within a temperature range of 40 to 120°C (Chamber 1: 60°C; Chamber 2: 80°C; Chamber 3: 100°C; Chamber 4: 100°C). (3) A dry film was prepared by laminating a second film (polypropylene (PP) film) onto the appropriately dried coating formed on the first film. At this time, the thickness of the dried coating was adjusted to be in the range of 30 to 60 μm.

## EVALUATION EXAMPLE 1: Measurement of Photoreaction Rate

On an FR-4 Cu substrate, dry films of each photosensitive resin composition (white solder resist compositions (Table 1) and colored solder resist compositions (Table 2)) were laminated using a vacuum laminator (CVP-300; manufactured by Nichico Molton Co., Ltd.) under the conditions of a first chamber (60°C, vacuum pressure 3 hPa, press pressure 0.2 MPa, press time 10 seconds) and a second chamber (70°C, pressure 6 kgf/cm2, press time 20 seconds), followed by peeling of the PET film.

Using a DI exposure apparatus manufactured by Screen, exposure was carried out with a Kodak step tablet No. 0.2 (41 steps) as a photomask such that the integrated exposure dose measured by a cumulative light meter was 100 mJ/cm2 for colored films (blue, green, black) and 300 mJ/cm2 for white films, and the exposure step reached 20 to 28 steps. Development was then performed for 60 s using a 1.0% Na2CO3 aqueous solution at 30°C under a spray pressure of 0.2 MPa, followed by curing in an oven at 150°C for 60 min to obtain a cured product (solder resist layer) of the photosensitive resin layer.

After completion of primary curing, the cured product of the photosensitive resin layer peeled off with a knife was measured by FT-IR using an ATR diamond plate. Based on the obtained IR spectrum, the acrylate peak was identified and the degree of acrylate curing (photoreaction rate) was measured and shown in Table 3.

[Method for Calculating Photoreaction Rate]

(1) Samples of the composition before primary curing and the cured product after completion of primary curing were prepared.
(2) The uncured composition and the cured product were placed on a diamond plate and measured by FT-IR.
(3) Using the uncured composition as a reference, the reaction rate was calculated by comparing the vicinity of the acrylate peak (1394-1424 cm-1) of the cured product (calculation formula shown below).

Photoreaction Rate Calculation Formula: Height of acrylate peak of cured product (1394- 1424 cm-1)/height of acrylate peak of uncured composition (1394-1424 cm-1) × 100

◎: 70% ≤ photoreaction rate
◦: 60% ≤ photoreaction rate < 70%
Δ: 50% ≤ photoreaction rate < 60%
X: photoreaction rate < 50%

[Sensitivity]

On an FR-4 Cu substrate, dry films of each photosensitive resin composition (white solder resist compositions (Table 1) and colored solder resist compositions (Table 2)) were laminated using a vacuum laminator (CVP-300; manufactured by Nichico Molton Co., Ltd.) under the conditions of a first chamber (60°C, vacuum pressure 3 hPa, press pressure 0.2 MPa, press time 10 s) and a second chamber (70°C, pressure 6 kgf/cm2, press time 20 s). After being left at room temperature, the PET film was peeled off.

Using a DI exposure apparatus manufactured by Screen, exposure was carried out with a Kodak step tablet No. 0.2 (41 steps) as a photomask such that the integrated exposure dose measured by a cumulative light meter was 100 mJ/cm2 for colored films and 300 mJ/cm2 for white films. Development was then performed for 60 s using a 1.0% Na2CO3 aqueous solution at 30°C under a spray pressure of 0.2 MPa, followed by curing in an oven at 150°C for 60 min to obtain a cured coating film, and the gloss level thereof was visually evaluated and shown in Table 3.

**EVALUATION EXAMPLE 2: Measurement of Moisture Absorption and Water Vapor Transmission Rate**

[Moisture Absorption]

Dry films were prepared by laminating the photosensitive resin compositions according to the Examples and Comparative Examples on a PET film using a vacuum laminator (CVP-300; manufactured by Nichico Molton Co., Ltd.) under the conditions of a first chamber (60°C, vacuum pressure 3 hPa, press pressure 0.2 MPa, press time 10 seconds) and a second chamber (70°C, pressure 6 kgf/cm2, press time 20 seconds), followed by peeling of the PET film.

Using a DI exposure apparatus manufactured by Screen, exposure was carried out with a Kodak step tablet No. 0.2 (41 steps) as a photomask such that the integrated exposure dose measured by a cumulative light meter was 100 mJ/cm2 for colored films and 300 mJ/cm2 for white films, and the exposure step reached 20 to 28 steps. Development was then performed for 60 s using a 1.0% Na2CO3 aqueous solution at 30°C under a spray pressure of 0.2 MPa, followed by curing in an oven at 150°C for 60 min to obtain cured products. The moisture absorption (water absorption rate) of the dry films prepared in the Examples and Comparative Examples was measured according to ASTM D570, and the results are shown in Table 3.

<Method for Measuring Moisture Absorption>

(1) Prior to testing, the samples were pre-dried in an oven at (50 ± 2)°C for 24 hours.
(2) Before moisture absorption, the weight of each sample was measured (the composition samples were cut to 2 inches × 2 inches).
(3) The samples whose initial weights were measured were placed in a beaker containing purified distilled water and left at room temperature for 24 hours.

(4) After removal from the distilled water, surface moisture was wiped off and the sample weight was measured.
(5) The moisture absorption rate was calculated using the weights before and after the test.

◎: 0.5% ≤ moisture absorption < 1%
○: 1% ≤ moisture absorption < 2%
Δ: 2% ≤ moisture absorption < 5%
X: 5% or higher

[Water Vapor Transmission Rate]

Through repeated procedures identical to those for moisture absorption measurement, cured products having a thickness of 700 μm were obtained. These cured products were placed in a water vapor transmission rate (WVTR) apparatus, and the water vapor transmission rate was measured according to ASTM F1249. The results are shown in Table 3.

<Measurement temperature: 38±2°C, humidity 100%, measurement range 0.005-400 (g/$m^2$·day), measurement mode M1 (volume 1 $cm^3$)>

◎: 1 ≤ WVTR <10 (g/$m^2$·day)
○: 10 ≤ WVTR <20 (g/$m^2$·day)
Δ: 20 ≤ WVTR <33 (g/$m^2$·day)
X: WVTR ≥ 33 (g/$m^2$·day)

[Pencil Hardness]

Using cured coating films prepared in the same manner as in the sensitivity evaluation, pencils from B to 9H with flattened tips were pressed against the coating at an angle of approximately 45°, and the pencil hardness at which no peeling of the coating occurred was recorded and shown in Table 3.

[TABLE 3]

| | Photoreaction Rate (%) | Sensitivity (Stage) | Moisture Absorption | WVTR | Pencil Hardness |
|---|---|---|---|---|---|
| Ex. 1 | Δ | 22 | Δ | Δ | 5H |
| Ex. 2 | ○ | 25 | ○ | ○ | 6H |
| Ex. 3 | ◎ | 28 | ◎ | ◎ | 7H |
| Ex. 4 | ◎ | 28 | ◎ | ◎ | 8H |
| Ex. 5 | ◎ | 28 | ◎ | ◎ | 8H |
| Ex. 6 | ◎ | 28 | ○ | ○ | 6H |
| Ex. 7 | ◎ | 28 | ◎ | ◎ | 7H |
| Ex. 8 | ◎ | 28 | ◎ | ◎ | 7H |
| Ex. 9 | ◎ | 28 | ◎ | ◎ | 8H |
| Ex. 10 | Δ | 22 | Δ | Δ | 5H |
| Ex. 11 | ◎ | 28 | ◎ | ◎ | 7H |
| Ex. 12 | ◎ | 28 | ◎ | ◎ | 7H |
| Ex. 13 | ◎ | 28 | ◎ | ◎ | 8H |
| Ex. 14 | ◎ | 28 | ◎ | ◎ | 7H |
| Ex. 15 | ◎ | 28 | ◎ | ◎ | 7H |
| Ex. 16 | ◎ | 28 | ◎ | ◎ | 7H |
| Ex. 17 | ◎ | 28 | ◎ | ◎ | 7H |

(continued)

| | Photoreaction Rate (%) | Sensitivity (Stage) | Moisture Absorption | WVTR | Pencil Hardness |
|---|---|---|---|---|---|
| Ex. 18 | ◎ | 28 | ◎ | ◎ | 7H |
| C. Ex. 1 | Δ | 23 | Δ | Δ | 4H |
| C. Ex. 2 | Δ | 22 | Δ | Δ | 4H |
| C. Ex. 3 | Δ | 21 | Δ | Δ | 4H |
| C. Ex. 4 | X | 20 | X | X | 3H |
| C. Ex. 5 | ○ | 28 | ○ | ○ | 6H |
| C. Ex. 6 | ○ | 28 | ○ | ○ | 6H |
| C. Ex. 7 | ○ | 28 | ○ | ○ | 6H |
| C. Ex. 8 | Δ | 23 | Δ | Δ | 4H |
| C. Ex. 9 | Δ | 22 | Δ | Δ | 4H |
| C. Ex. 10 | Δ | 21 | Δ | Δ | 4H |
| C. Ex. 11 | X | 20 | X | X | 3H |

Referring to FIG. 1 and Table 3, when TMO was included as the photopolymerization initiator, the UV absorption in the range of 350-430 nm was higher than that of other photopolymerization initiators (TPO, TPO-L, Omnipol TP). Due to the high UV absorbance of the TMO photopolymerization initiator, sensitivity and photoreaction rate at the same exposure dose were higher than those of other initiators. During curing of the photosensitive composition, the photoreactivity and photoreaction rate were excellent, and the degree and density of curing were high, thereby enabling formation of a harder cured coating film.

Referring to FIGS. 2a and 2b and Table 3, when TMO was included as the photopolymerization initiator, the high photoreaction rate increased the degree and density of curing, resulting in formation of a hard cured coating film with reduced moisture penetration and thus reduced moisture absorption. In addition, although the molecular structure of the TMO photopolymerization initiator is similar to that of the TPO initiator, TMO includes additional methyl groups compared to TPO, thereby exhibiting more hydrophobic characteristics, which facilitates suppression of moisture absorption and penetration.

Specifically, Examples 3 to 9 and Examples 11 to 18 exhibited higher photoreaction rates than Comparative Examples 1 to 11. Due to these high photoreaction rates, hard cured coating films were formed, exhibiting high pencil hardness and surface hardness. The hardened coating films effectively prevented moisture penetration, resulting in lower water vapor transmission rates and moisture absorption. Owing to the low WVTR and moisture absorption, oxidation and corrosion of copper included in printed wiring boards formed on the cured coating films were significantly reduced, and no peeling, discoloration, or elution phenomena were observed.

In addition, Examples 3 to 9 and Examples 11 to 18 generally exhibited high photoreaction rates and high sensitivity, and the cured coating films were hard, resulting in excellent pencil hardness overall (6H-8H). However, in Examples 1 and 10, the content of TMO as the photopolymerization initiator was relatively low, resulting in a lower photoreaction rate and relatively insufficient surface curing; therefore, the pencil hardness was lower (5H) compared to other Examples.

In contrast, Comparative Examples 1 to 4 and Comparative Examples 8 to 11 generally exhibited low photoreaction rates, resulting in soft cured coating films and low pencil hardness. However, in Comparative Examples 5 to 7, the pencil hardness was relatively high (6H) due to an increase in thermal curing caused by the thermal curing catalyst.

**EVALUATION EXAMPLE 3: BHAST Test**

The dry films prepared in each of the Examples and Comparative Examples were laminated on a substrate on which comb-shaped electrodes (line/space = 50 μm/50 μm) were formed, using a vacuum laminator (CVP-300; manufactured by Nichico Molton Co., Ltd.). Lamination was performed in a first chamber at 60°C under a vacuum pressure of 3 hPa for 10 s, followed by pressing at a press pressure of 0.2 MPa for 10 s to obtain evaluation substrates. After peeling the PET film, exposure was carried out using a DI exposure apparatus (Screen Co., Ltd.) such that the integrated exposure dose was 100 mJ/cm2 for colored films and 300 mJ/cm2 for white films. Development was then performed for 60 s using a 1% Na2CO3 aqueous solution at 30°C under a spray pressure of 0.2 MPa, followed by curing in an oven at 150°C for 60 min to form cured coating films, thereby preparing HAST evaluation substrates. These evaluation substrates were

placed in a high-temperature/high-humidity chamber under conditions of 110°C and 85% relative humidity, a voltage of 20 V was applied, and a BHAST (Highly Accelerated Stress Test) was conducted for 250 hours. After 250 hours, discoloration and elution of the cured coating films of the dry films were evaluated according to the criteria below (equipment manufacturer: Espec Co., Ltd.; ion migration system; equipment name: NY IM1064). After the evaluation, the degree of ion migration, HAST resistance, and adhesion after HAST were examined. In addition, using a spectrophotometer (CM-2600d, Konica Minolta Sensing, Inc.), the reflectance at a wavelength of 450 nm was measured for cured coating films with a thickness of 60 μm. The results are shown in Tables 4 and 5.

[Ion Migration]

◎: No ion migration occurred.
○: Slight ion migration occurred, but no corrosion of the electrodes was observed.
Δ: Some ion migration occurred and slight corrosion of the electrodes was observed.
X: Severe ion migration occurred and the electrodes were severely corroded.

[HAST Resistance]

○: Neither discoloration nor elution was observed.
Δ: Slight discoloration or elution was visually observed.
X: Significant discoloration or elution was visually observed.

[Adhesion After HAST Test]

○: 90% or more of the cross-hatch grid remained.
Δ: 80% to less than 90% of the cross-hatch grid remained.
×: Less than 70% of the cross-hatch grid remained.

[Reflectance]

◎: Reflectance ≥ 90%
○: 85% ≤ Reflectance < 90%
Δ: 80% ≤ Reflectance < 85%
X: Reflectance < 75%

[Table 4]

| | Ion Migration | HAST Resistance | Adhesion after HAST |
|---|---|---|---|
| Ex. 1 | Δ | Δ | Δ |
| Ex. 2 | ○ | ○ | ○ |
| Ex. 3 | ◎ | ○ | ○ |
| Ex. 4 | ◎ | ○ | ○ |
| Ex. 5 | ◎ | ○ | ○ |
| Ex. 6 | ◎ | ○ | ○ |
| Ex. 7 | ◎ | ○ | ○ |
| Ex. 8 | ◎ | ○ | ○ |

(continued)

| | Ion Migration | HAST Resistance | Adhesion after HAST |
|---|---|---|---|
| Ex. 9 | ◎ | ○ | ○ |
| Ex. 10 | Δ | Δ | Δ |
| Ex. 11 | ◎ | ○ | ○ |
| Ex. 12 | ◎ | ○ | ○ |
| Ex. 13 | ◎ | ○ | ○ |
| Ex. 14 | ◎ | ○ | ○ |
| Ex. 15 | ◎ | ○ | ○ |
| Ex. 16 | ◎ | ○ | ○ |
| Ex. 17 | ◎ | ○ | ○ |
| Ex. 18 | ◎ | ○ | ○ |
| C. Ex. 1 | Δ | Δ | Δ |
| C. Ex. 2 | Δ | Δ | Δ |
| C. Ex. 3 | Δ | Δ | Δ |
| C. Ex. 4 | X | X | X |
| C. Ex. 5 | ○ | Δ | Δ |
| C. Ex. 6 | ○ | Δ | Δ |
| C. Ex. 7 | ○ | Δ | Δ |
| C. Ex. 8 | Δ | Δ | Δ |
| C. Ex. 9 | Δ | Δ | Δ |
| C. Ex. 10 | Δ | Δ | Δ |
| C. Ex. 11 | Δ | Δ | Δ |

Referring to FIG. 3 and Table 4, the photoreaction rate in Examples 3 to 9 and Examples 11 to 18, which include the photopolymerization initiator TMO, is higher than that of Comparative Examples 1 to 11 using other photoinitiators. As a result, when curing the photosensitive compositions at the same exposure dose, photoreactivity is excellent, and the degree and density of curing increase, thereby enabling formation of hard cured coating films. Accordingly, moisture penetration into the cured coating films is reduced, and moisture absorption is decreased. Therefore, even when the BHAST test is conducted for 250 hours under high-temperature and high-humidity conditions, ion migration and corrosion of the electrodes do not occur. In addition, no discoloration or elution is observed, and no significant problems are found in the adhesion test. However, in Examples 1, 2, and 10, since the content of TMO is relatively low, the photoreaction rate is relatively lower than that of Examples 3 to 9 and Examples 11 to 18, and the cured coating films are formed relatively soft. As a result, adhesion and resistance after HAST are relatively reduced, and slight elution occurs.

In Comparative Examples 1 to 4 and Comparative Examples 8 to 11, moisture absorption and penetration increase, severe ion migration and corrosion of the copper electrodes occur, discoloration or elution is observed, and adhesion problems arise. Consequently, when displays or electronic products are exposed to moisture-containing environments for a long period of time, there is a possibility that long-term reliability problems may occur due to corrosion of the electrodes.

[Table 5]

| | Initial Reflectance | Initial b value(yellowing) | Reflectance after HAST | b value (yellowing) after HAST |
|---|---|---|---|---|
| Ex. 1 | ○ | 3.6 | Δ | 3.9 |
| Ex. 2 | ◎ | 2.1 | O | 2.5 |
| Ex. 3 | ◎ | 1.9 | O | 2.4 |
| Ex. 4 | ◎ | 1.9 | Δ | 2.5 |

(continued)

| | Initial Reflectance | Initial b value(yellowing) | Reflectance after HAST | b value (yellowing) after HAST |
|---|---|---|---|---|
| C. Ex. 1 | ○ | 3.0 | X | 7.2 |
| C. Ex. 2 | ○ | 3.1 | X | 7.3 |
| C. Ex. 3 | ○ | 3.5 | X | 7.4 |
| C. Ex. 4 | Δ | 3.9 | X | 7.7 |

Referring to Table 5, it can be confirmed that Examples 1 to 4 exhibit higher reflectance after the HAST test than Comparative Examples 1 to 4. This is because Examples 1 to 4 have high photoreaction rates and low moisture absorption and water vapor transmission rates, such that even when BHAST evaluation is performed under high-temperature and high-humidity environments, moisture absorption and penetration into the cured coating films (solder resist layers) do not readily occur, resulting in very little oxidation and corrosion of copper, and no discoloration or elution phenomena.

**EVALUATION EXAMPLE 4: Thermal Analysis and Outgas Measurement**

[Thermal Analysis Experiment]

In order to confirm the thermal decomposition temperatures of the photopolymerization initiators TMO, TPO, Omnipol TP, and TPO-L, thermogravimetric analysis was performed using a simultaneous thermal analyzer (for example, TGA, TGA5500, TA Instruments Inc.). The thermal decomposition temperature (Td) was measured by TGA under an air atmosphere, with a sample weight of 10 to 20 mg, using an aluminum pan (non-hermetic), a heating rate of 10°C/min, and a measurement temperature range of 25 to 500°C. The thermal decomposition temperature Td was defined as the temperature at which a 5% weight loss occurred in the thermogravimetric analysis. The 5% weight-loss temperatures of each initiator were measured according to the method described below and are shown in Table 6.

[Outgas Content Measurement]

On a PET film, the photosensitive resin compositions according to the Examples and Comparative Examples were laminated using a vacuum laminator (CVP-300; manufactured by Nichico Molton Co., Ltd.) under conditions of a first chamber at 60°C, vacuum pressure of 3 hPa, and vacuum time of 10 s to prepare dry films, and the PET film was peeled off.

Using a DI exposure apparatus manufactured by Screen Co., Ltd., full-surface exposure was carried out using a Kodak step tablet No. 2 (41 steps) as a photomask, such that the integrated exposure dose was 100 mJ/cm2 for colored films and 300 mJ/cm2 for white films, and the exposure level was adjusted to step 23. Subsequently, development was performed for 60 seconds using a 1.0% Na2CO3 aqueous solution at 30°C under a spray pressure of 0.2 MPa. Thereafter, curing was performed in an oven at 150°C for 60 min to obtain cured products of the photosensitive resin layers.

Powder samples were collected from the prepared resist layers and introduced into a thermal desorption unit (TDU) manufactured by Gerstel. Specifically, using helium as a purge gas (50 mL/min), the powder samples were heated from 30°C at a rate of 60°C/min, maintained at 150°C for 60 min, and desorbed components were trapped at -50°C. The collected outgas components were separated and analyzed using a gas chromatograph-mass spectrometer (8890/5977B, Agilent Technologies). Quantification was performed by conversion to n-dodecane equivalents, and the outgas content was expressed as a weight percentage based on the weight of the photopolymerization initiator contained in the cured photosensitive resin layer.

The measurement conditions for gas chromatography were as follows: Column: Agilent Technologies capillary column DB-1MS (length 30 m, inner diameter 0.25 mm, film thickness 0.25 μm); Detector: MS (ITQ900); Carrier gas: helium; Injector temperature: 300°C; Detector temperature: 230°C; Column temperature conditions: initial temperature 50°C, held at 50°C for 2 min after sample injection, then increased to 300°C at 12°C/s, and held at 300°C for 10 min.

The outgas contents of each Example and Comparative Example were measured according to the method described below and are shown in Table 6.

<Outgas Content Evaluation Method>

In TD-GC-MS analysis, peaks corresponding to the photopolymerization initiators were identified. The peak intensities were expressed in μg/g, representing the amount of gas generated per 1 g of sample converted to n-dodecane equivalents, and the total outgas content was calculated as the sum of the photopolymerization initiator peaks. At this time, the peak area ratio of the photopolymerization initiator to that of the n-dodecane reference in GC-MS was calculated

according to the following equation.

(Outgas Content Evaluation Criteria)

◎: Outgas content < 1,000 ppm
○: 1,000 ppm ≤ Outgas content < 3,000 ppm
Δ: 3,000 ppm ≤ Outgas content < 5,000 ppm
X: Outgas content ≥ 5,000 ppm

[Table 6]

| | Thermal decomposition temperature (Td) of photopolymerization initiator (°C) | Outgas content |
|---|---|---|
| Ex. 1 | 263 | ◎ |
| Ex. 2 | 263 | ◎ |
| Ex. 3 | 263 | ◎ |
| Ex. 10 | 263 | ◎ |
| Ex. 11 | 263 | ◎ |
| C. Ex. 1 | 233 | ○ |
| C. Ex. 2 | 191 | X |
| C. Ex. 3 | 201 | Δ |
| C. Ex. 8 | 233 | ○ |
| C. Ex. 9 | 191 | X |
| C. Ex. 10 | 201 | Δ |

Referring to Table 6, the photopolymerization initiator TMO exhibits the highest decomposition temperature (Td, 5% weight-loss temperature) compared with the photopolymerization initiators TPO and TPO-L. Accordingly, the amount of photopolymerization initiator decomposed at high temperatures is smaller. As shown in the comparison between Examples 1, 2, 3, 10, 11, which include the TMO photopolymerization initiator, and Comparative Examples 1, 2, 3, 8, 9, 10, which include other photopolymerization initiators, the outgas content generated during curing at the same temperature is significantly lower in the compositions containing TMO.

When a large amount of outgas is generated, discoloration of encapsulant layers may occur, and when applied to displays or electronic products, there is a possibility that reliability issues may arise during long-term use.

**Claims**

**1.** A photosensitive resin composition comprising:

(A) a carboxyl group-containing resin;
(B) a photopolymerization initiator; and
(C) an inorganic filler,
wherein the photopolymerization initiator (B) includes one or more moieties represented by Chemical Formula 1:

<Chemical Formula 1>

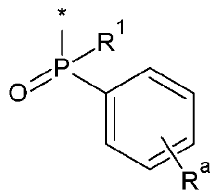

wherein,
$R^1$ is hydrogen, a substituted or unsubstituted alkyl group of 1 to 10 carbon atoms, or a substituted or unsubstituted non-aromatic cyclic group or aromatic group of 6 to 20 carbon atoms,
$R^a$ is a substituted or unsubstituted alkyl group of 1 to 10 carbon atoms,
wherein substituents of the substituted alkyl group of 1 to 10 carbon atoms, the substituted non-aromatic cyclic group of 6 to 20 carbon atoms, or the aromatic group are alkyl groups of 1 to 10 carbon atoms, and
* represents a bonding site with an adjacent atom.

**2.** The photosensitive resin composition of claim 1,

wherein the photopolymerization initiator (B) comprises one or more moieties represented by Chemical Formula 1A:

<Chemical Formula 1A>

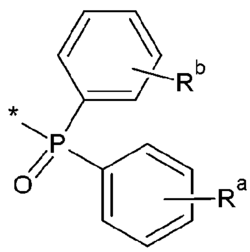

wherein,
$R^a$ and $R^b$ are each independently a substituted or unsubstituted alkyl group of 1 to 10 carbon atoms, with substituents of the substituted alkyl group of 1 to 10 carbon atoms being C1-C10 alkyl groups, and
* represents a bonding site with an adjacent atom.

**3.** The photosensitive resin composition of claim 1,
wherein the photopolymerization initiator (B) is in a solid state at room temperature (25°C) and has a weight-average molecular weight ($M_w$) in a range of 350 to 900 g/mol.

**4.** The photosensitive resin composition of claim 1,
wherein the photopolymerization initiator (B) has a thermal decomposition temperature of 240°C or higher.

**5.** The photosensitive resin composition of claim 1,
wherein the photopolymerization initiator (B) is represented by Chemical Formula 2.

<Chemical Formula 2>

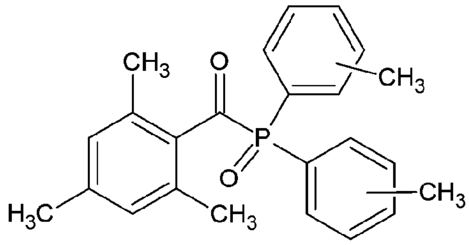

6. The photosensitive resin composition of claim 1, further comprising one or more selected from the group consisting of an oxime-based photopolymerization initiator, an epoxy resin, an acrylic resin, a thermosetting catalyst, a dispersant, and a colorant.

7. The photosensitive resin composition of claim 6, wherein the thermosetting catalyst is one or more selected from the group consisting of imidazole, melamine, and dicyandiamide, or derivatives thereof.

8. The photosensitive resin composition of claim 6, wherein the colorant is one or more selected from the group consisting of a white pigment, a black pigment, a blue pigment, and a green pigment.

9. The photosensitive resin composition of claim 1, wherein the content of the photopolymerization initiator (B) is 0.06 to 20 wt% based on the total weight of the composition.

10. The photosensitive resin composition of claim 1, wherein, when the photosensitive resin composition is cured to a thickness of 60 μm, a reflectance at 450 nm is 90% or higher as measured by a spectrophotometer.

11. The photosensitive resin composition of any one of claims 1 to 10, wherein a cured product obtained by curing the photosensitive resin composition has a moisture absorption rate of 5% or less as measured according to ASTM D570.

12. The photosensitive resin composition of any one of claims 1 to 10, wherein a cured product obtained by curing the photosensitive resin composition has a water vapor transmission rate (WVTR) of 33 $g/m^2$·day or less as measured according to ASTM F1249.

13. A dry film comprising a photosensitive resin layer formed by coating and drying the photosensitive resin composition of any one of claims 1 to 10 on a first film.

14. A cured product obtained by curing the photosensitive resin composition of any one of claims 1 to 10 or a photosensitive resin layer of a dry film obtained therefrom.

15. A printed wiring board comprising the cured product of claim 14 as a solder resist.

FIG. 1

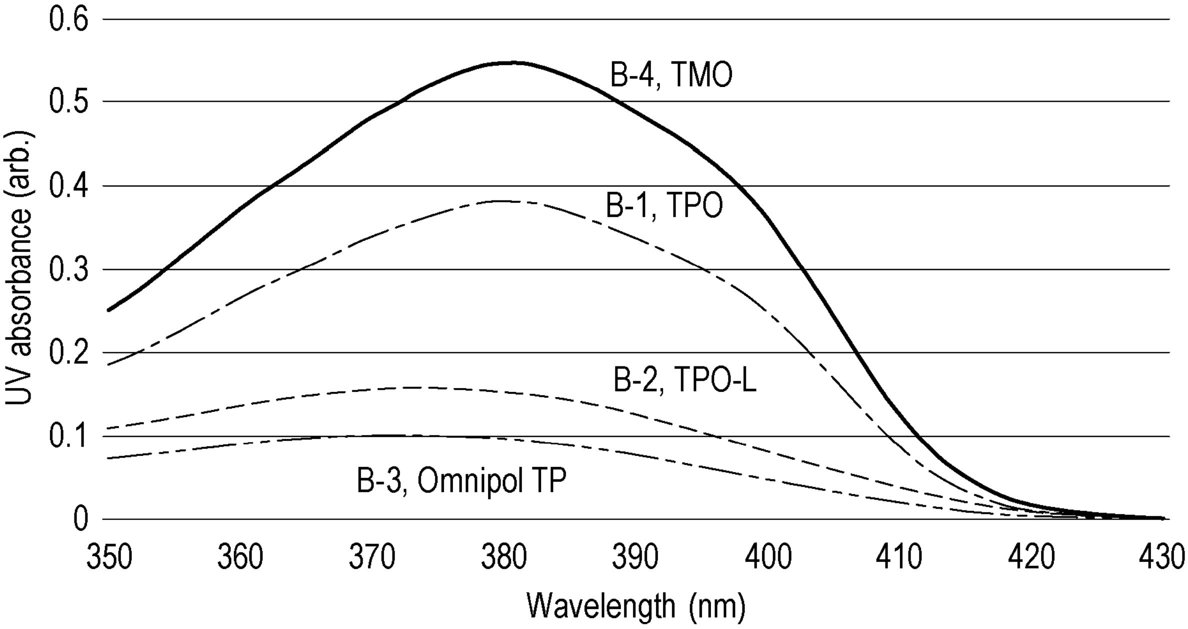
0.6
0.5
0.4
0.3
0.2
0.1
0
UV absorbance (arb.)
B-4, TMO
B-1, TPO
B-2, TPO-L
B-3, Omnipol TP
350
360
370
380
390
400
410
420
430
Wavelength (nm)

# FIG. 2A

## Example 3

| | | |
|---|---|---|
| Transmission Rate: | 9.239836 | gm / [m2 - day] |
| Permeation: | 9.239836 | gm - mil [m2 - day] |

DATA POINTS

| Time | Rate/Event | Time | Rate/Event | Time | Rate/Event | Time | Rate/Event |
|---|---|---|---|---|---|---|---|
| 0:00 | Condition | 1:29 | Test | 2:30 | 67.27879 | 5:30 | 7.333192 |
| 8:00 | 5.025633 | 11:01 | 6.424741 | 14:01 | 7.355115 | 17:01 | 8.225353 |
| 20:02 | 8.666753 | 23:02 | 6.114683 | 25:32 | 7.970652 | 25:32 | 9.239836 |

Transmission Rate Data Graph

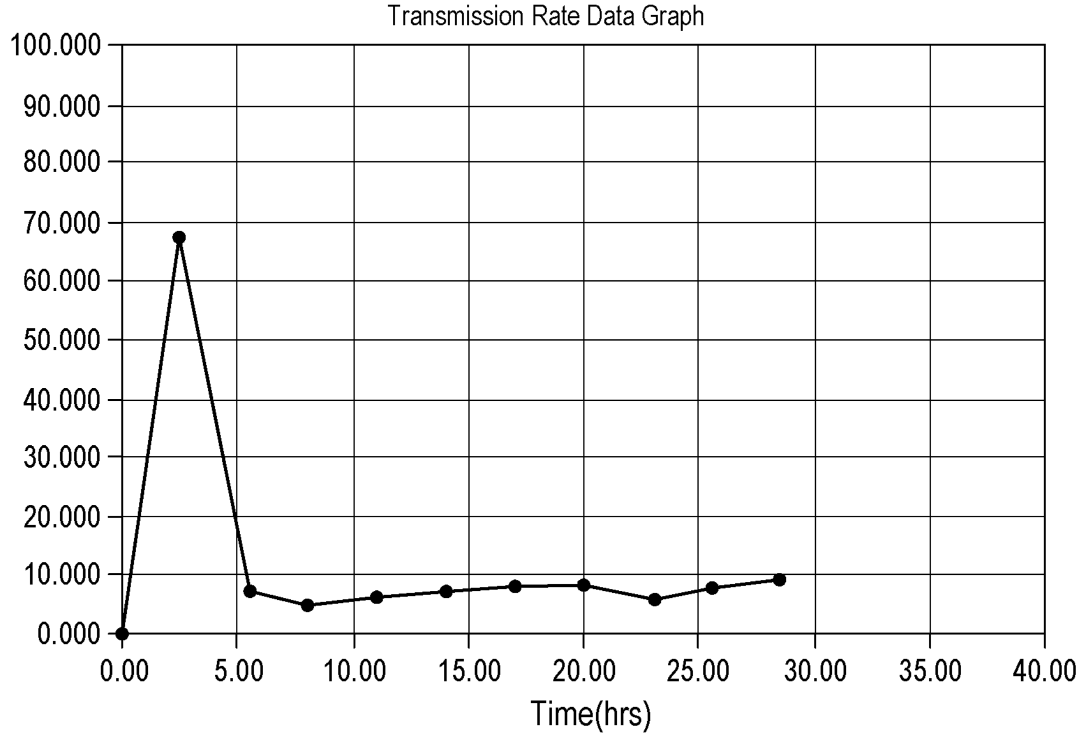

# FIG. 2B

## Comparative Example 1

| | | |
|---|---|---|
| Transmission Rate: | 33.17768 | gm / [m2 - day] |
| Permeation: | 33.17768 | gm - mil [m2 - day] |

DATA POINTS

| Time | Rate/Event | Time | Rate/Event | Time | Rate/Event | Time | Rate/Event |
|---|---|---|---|---|---|---|---|
| 0:00 | Condition | 1:29 | Test | 3:00 | 24.91410 | 6:00 | 24.08711 |
| 9:00 | 25.88224 | 11:31 | 27.66507 | 14:31 | 29.17617 | 17:31 | 30.66885 |
| 20:32 | 31.77894 | 23:32 | 30.45197 | 26:32 | 32.24566 | 29:03 | 33.17768 |

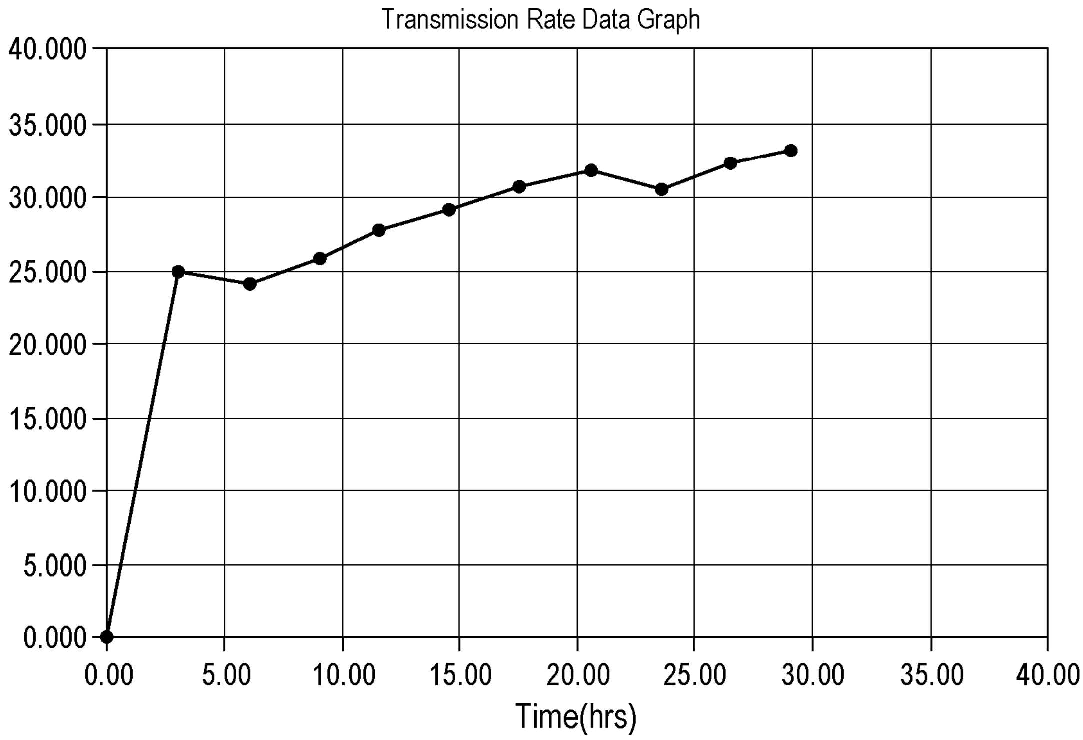

FIG. 3

Example 3

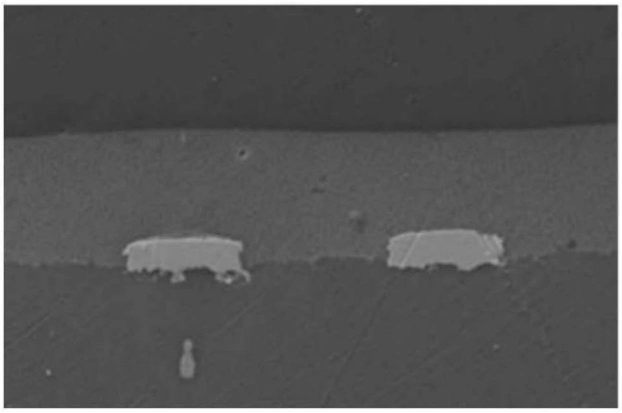

Comparative Example 1

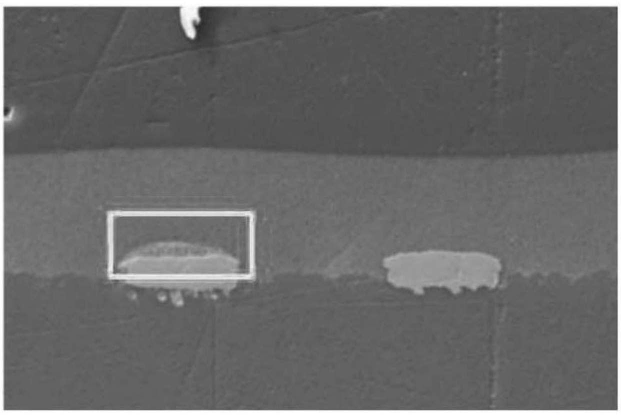

**INTERNATIONAL SEARCH REPORT**

International application No.
**PCT/KR2025/007183**

**A. CLASSIFICATION OF SUBJECT MATTER**

**G03F 7/004**(2006.01)i; **G03F 7/075**(2006.01)i; **G03F 7/027**(2006.01)i; **G03F 7/035**(2006.01)i; **G03F 7/031**(2006.01)i; **G03F 7/105**(2006.01)i

According to International Patent Classification (IPC) or to both national classification and IPC

**B. FIELDS SEARCHED**

Minimum documentation searched (classification system followed by classification symbols)

G03F 7/004(2006.01); B32B 15/20(2006.01); C08G 18/22(2006.01); C08G 18/48(2006.01); C08G 18/67(2006.01); C08L 61/14(2006.01); C09D 11/101(2014.01); C09D 11/30(2014.01); C09J 133/08(2006.01); C09J 7/10(2018.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN Express (Registry, Caplus), Google & keywords: 감광성 수지(photosensitive resin), 광중합 개시제(photopolymerization initiator), 충진제(filler)

**C. DOCUMENTS CONSIDERED TO BE RELEVANT**

| Category* | Citation of document, with indication, where appropriate, of the relevant passages | Relevant to claim No. |
|---|---|---|
| X | CN 117736533 A (SHENGYI TECHNOLOGY CO., LTD.) 22 March 2024 (2024-03-22)<br>abstract; claims 1-3, 6; paragraph [0040] | 1-15 |
| A | CN 116813864 A (SHANGHAI HANSI INDUSTRIAL CO., LTD.) 29 September 2023 (2023-09-29)<br>claims 1-16 | 1-15 |
| A | CN 117304740 A (ZHEJIANG TIGER PRINTING NEW MATERIAL TECHNOLOGY CO., LTD.) 29 December 2023 (2023-12-29)<br>claims 1-6 | 1-15 |
| A | CN 117567966 A (ZHEJIANG JIUJIU NEW MATERIAL TECHNOLOGY CO., LTD.) 20 February 2024 (2024-02-20)<br>claims 1-10 | 1-15 |
| A | CN 116874705 A (YONGJIANG LABORATORY et al.) 13 October 2023 (2023-10-13)<br>claims 1-10 | 1-15 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **01 September 2025** | **02 September 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2025/007183**

| Patent document cited in search report | Publication date (day/month/year) | Patent family member(s) | Publication date (day/month/year) |
|---|---|---|---|
| CN 117736533 A | 22 March 2024 | None | |
| CN 116813864 A | 29 September 2023 | None | |
| CN 117304740 A | 29 December 2023 | None | |
| CN 117567966 A | 20 February 2024 | None | |
| CN 116874705 A | 13 October 2023 | None | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020220086524 A
- KR 1020240147558 A


### Non-patent literature cited in the description


- Color Index. The Society of Dyers and Colourists